Europäisches Patentamt

European Patent Office

Office européen des brevets

(19)

(11) EP 1 233 626 A1

(12) **EUROPEAN PATENT APPLICATION**

(43) Date of publication:
21.08.2002 Bulletin 2002/34

(51) Int Cl.⁷: H04N 7/52

(21) Application number: 02250478.1

(22) Date of filing: 24.01.2002

(84) Designated Contracting States:
AT BE CH CY DE DK ES FI FR GB GR IE IT LI LU
MC NL PT SE TR
Designated Extension States:
AL LT LV MK RO SI

(30) Priority: 24.01.2001 US 263792 P
14.02.2001 US 268840 P
21.08.2001 US 314137 P

(71) Applicant: Broadcom Corporation
Irvine, California 92618 (US)

(72) Inventor: Pasqualino, Christopher
Glendora, CA 91741 (US)

(74) Representative:
McLeish, Nicholas Alistair Maxwell et al
Boult Wade Tennant
Verulam Gardens
70 Gray's Inn Road
London WC1X 8BT (GB)

(54) **Digital video interface supporting transport of audio and auxiliary data**

(57) The present invention relates to a method of transporting video and audio data. The method includes receiving, by a first transmitter (CE transmitter, for example),a video data stream and an audio data stream. The first transmitter generates a composite data stream from the audio data stream and the video data stream. The first transmitter communicates the composite data stream to a second transmitter (DVI 1.0 transmitter, for example), which in turn transmits the composite data stream to a remote receiver.

Fig. 1

**Description**

**CROSS-REFERENCE TO RELATED APPLICATIONS**

This application is related to, and claims benefit of and priority from, Provisional Application No. 60/263,792 filed January 24, 2001, titled "System and Method for Increased Data Capacity of a Digital Video Link"; Provisional Application No. 60/268,840 filed February 14, 2001, titled "Digital Visual Interface With Audio", and Provisional Application No. 60/314,137 filed August 21, 2001, titled "Digital Visual Interface Supporting Transport of Audio and Auxiliary Data", the complete subject matter of each of which is incorporated herein by reference in its entirety.

This application is a continuation-in-part of Non-Provisional Application No. 09/951,289 filed September 12, 2001, titled "System and Method for Increased Data Capacity of a Digital Video Link" and Non-Provisional Application No. 09/951,671 filed September 12, 2001, titled "Digital Visual Interface With Audio".

**BACKGROUND OF THE INVENTION**

The Digital Visual Interface Version 1.0 (hereinafter referred to as "DVI") specification incorporated herein by reference in its entirety provides a high-speed digital connection for visual data types that are display technology independent. The DVI interface (alternatively referred to as a "DVI Link" or "Link"), is primarily focused towards providing a connection between a computer and its display device. The DVI specification meets the needs of all segments of the PC industry (workstation, desktop, laptop, etc). The DVI interface: (1) enables content to remain in the lossless digital domain from creation to consumption; (2) enables content to remain display technology independent; (3) supports plug and play through hot plug detection; (4) supports EDID and DDC2B protocols; and (5) provides digital and analog support in a single connector.

The DVI specification meets the needs of the Consumer Electronics (hereinafter referred to as the "CE") industry, as it provides for the transmission of high quality, multi-channel audio or other auxiliary data over the DVI link. Digital Video, Audio and Auxiliary (alternatively referred to as "DVAAA") is representative of the standard for use in the CE industry for transmitting high quality, multi-channel audio and auxiliary data over a digital video link.

Further limitations and disadvantages of conventional, traditional and proposed approaches will become apparent to one of skill in the art, through comparison of such systems with the present invention as set forth in the remainder of the present application with reference to the drawings.

**BRIEF SUMMARY OF THE INVENTION**

Aspects of the present invention may be found in a method of transporting video and audio data. In one embodiment, the method comprises receiving, by a first transmitter (CE transmitter, for example), a video data stream and an audio data stream. The first transmitter generates a composite data stream from the audio data stream and the video data stream. The first transmitter communicates the composite data stream to a second transmitter (DVI 1.0 transmitter, for example), which in turn transmits the composite data stream to a remote receiver.

One embodiment of the present invention relates to a method of communicating data over a communications link, comprising shortening a blanking period in the data to accommodate auxiliary data. This method includes modifying at least one HYSNC signal in the data to accommodate the auxiliary data, wherein the auxiliary data includes audio data, status information, other auxiliary data, etc.

Yet another embodiment of the present invention relates to a method of communicating data over a communications link, comprising shortening a blanking period in the data to accommodate auxiliary data, including modifying a HYSNC signal in all frames in which the auxiliary data is to be transmitted. In this embodiment, the VSYNC signal may be modified by inserting a notch into the VYSNC signals to indicate the presence of auxiliary information.

Yet another embodiment of the present invention relates to a system for communicating data and auxiliary data over a video communications link, where the system includes a reformatter and a transmitter. The reformatter is adapted to shorten a blanking period in the data to accommodate auxiliary data, forming at least one frame. The transmitter communicates with the reformatter and is adapted to transmit the at least one frame over the communications link.

These and other advantages and novel features of the present invention, as well as details of an illustrated embodiment thereof, will be more fully understood from the following description and drawings.

**BRIEF DESCRIPTION OF SEVERAL VIEWS OF THE DRAWINGS**

Fig. 1 illustrates the amount of available audio bandwidth contemplated for use with one embodiment of the interface of the present invention.

Fig. 2 illustrates general system architecture of a transmitter in accordance with one embodiment of the present invention.

Fig. 3 illustrates general system architecture of a receiver in accordance with one embodiment of the present invention.

Fig. 4 illustrates a two-dimensional representation of a typical video input frame.

Fig. 5 illustrates a modified video frame definition in accordance with one embodiment of the present invention.

Fig. 6 illustrates one embodiment of the system architecture of a transmitter frame reformatter in accordance with one embodiment of the present invention.

Fig. 7 illustrates an example of a timing diagram demonstrating the timing that may be used for audio insertion in accordance with one embodiment of the present invention.

Fig. 8 illustrates an example of an A_CTL3 signal generation timing diagram in accordance with one embodiment of the present invention.

Fig. 9 illustrates an example of an A_VSNYC definition and CTL3 timing in accordance with one embodiment of the present invention.

Fig. 10 illustrates a frame timing diagram for use when transitioning from a DVI 1.0 mode to a CE mode in accordance with one embodiment of the present invention.

Fig. 11 illustrates a frame timing diagram for use when transitioning from a CE mode to DVI 1.0 mode in accordance with one embodiment of the present invention.

Fig. 12 illustrates a line header timing diagram in accordance with one embodiment of the present invention.

Fig. 13 summarizes the general characteristics of the timing at various stages in a communications link in accordance with one embodiment of the present invention.

Fig. 14 illustrates a timing diagram of a single clocking example of audio time division multiplexing in accordance with one embodiment of the present invention.

Fig. 15 illustrates a timing diagram of a double clocking example of audio time division multiplexing in accordance with one embodiment of the present invention.

Fig. 16 illustrates an example of an audio transmission system using coherent audio and pixel clocks in accordance with one embodiment of the present invention.

Fig. 17 illustrates an example of an audio transmission system using non-coherent audio and pixel clocks in accordance with one embodiment of the present invention.

Fig. 18 illustrates an example of an audio clock recovery system that may be implemented to recover ACLK in accordance with one embodiment of the invention.

Fig. 19 illustrates an example of single channel error correction coding block data flow in accordance with one embodiment of the present invention.

Fig. 20 illustrates are exemplary steps in a Reed Solomon encoding process in accordance with one embodiment of the present invention.

Fig. 21 illustrates an extension field element generator for use in one embodiment of the present invention.

Fig. 22 illustrates an LFSR encoder for an RS[17,15] code in accordance with one embodiment of the present invention.

Fig. 23 illustrates a graph of error performance prediction for the RS[17,15] code in accordance with one embodiment of the present invention.

Fig. 24 provides detail regarding interleaver I/O results in accordance with one embodiment of the present invention.

Fig. 25 illustrates an input serial audio stream in accordance with one embodiment of the present invention.

Fig. 26 illustrates an example of data mapping for the serial audio stream of Fig. 25, in accordance with one embodiment of the present invention.

Fig. 27 illustrates a continuation of the data mapping of Fig. 26 for the serial audio stream of Fig. 25, in accordance with one embodiment of the present invention.

Fig. 28 depicts an audio application in which SPDIF data is input into a CE device according to one embodiment of the present invention.

Fig. 29 illustrates an example of data mapping for the audio application of Fig. 28, in accordance with one embodiment of the present invention.

Fig. 30 illustrates a continuation of the data mapping of Fig. 29 for the audio application of Fig. 28, in accordance with one embodiment of the present invention.

Fig. 31 depicts an audio application in which PCM data is input into a CE device according to one embodiment of the present invention.

Fig. 32 illustrates an example of data mapping for the audio application of Fig. 31, in accordance with one embodiment of the present invention.

Fig. 33 illustrates a continuation of the data mapping of Fig. 32 for the audio application of Fig. 31, in accordance with one embodiment of the present invention.

**DETAILED DESCRIPTION OF THE INVENTION**

Embodiments of the present invention relates to a digital visual interface that enables the PC and the CE industries to unite around one display interface specification (the DVAAA specification for example). Aspects of the present invention provide for a straightforward extension of the DVI specification to incorporate additional digital channels over the DVI link. Specifically, this extension provides means for transmitting a packaged audio stream over the DVI link.

The system of the present invention assists in providing a digital interface between a video generation device (for example PC, Set top box, DVD player, etc.) and a display device. The system of the present invention provides for a simple low-cost implementation of both the host and display while enabling monitor manufacturers and system providers to add feature rich values as appropriate for a specific application. Furthermore, the system of the present invention builds upon existing hardware to extend the overall functionality of the DVI interface or link.

The system of the present invention expands the DVI interface to enable the transmission of audio data over the DVI link in typical display applications. In one embodiment, a "consumer friendly" connector is provided, which is intended to reduce overall size and increase user friendliness for CE applications.

A digital interface for the computer to display interconnect has several benefits over the existing analog connectors used in the PC and CE space. A digital interface enables all content transferred over this interface to remain in the lossless digital domain from creation to consumption. In one embodiment, the digital interface is implemented with no assumption made as to the type of attached display technology.

As appropriate, this interface makes use of existing DVI, VESA, CEA, HDCP and DVAAA specifications to allow for simple low-cost implementations. Specifically VESA Extended Display Identification Data (EDID) and Display Data Channel (DDC) specifications are referenced for monitor identification and the VESA Monitor Timing Specification (DMT) and EIA/CEA-861, "A DTV Profile for Uncompressed High Speed Digital Interfaces" are referenced for the DTV/display timings, the complete subject matter of each of which is incorporated herein by reference in their entirety.

Due to the fact that multiple audio channels are often transmitted in a single transport stream, the present application uses the term "audio channel" or "channel" to generally refer to a single audio channel, for example. Following the precedents set by DVI 1.0 and DVAAA, the present application uses the term "link" to generally refer to a single transport stream (for example DVD audio, PCM, SPDIF, etc.) carrying one or more channels (for example DVD audio, PCM, SPDIF, etc.). Further, while the present application uses the term audio, audio data, audio bytes, etc., any data such as audio data, auxiliary data, status information, etc. is contemplated.

In one embodiment of the present invention, audio information may be partitioned into 16-bit segments called "audio pixels" for transmission across the link.

The system of the present invention is backward compatible with DVI 1.0, and may be referred to as a superset of the DVI 1.0 standard. It is also completely backward compatible with High-Bandwidth Digital Content Protection System (alternatively referred to as "HDCP 1.0"). In one embodiment, audio is encrypted with HDCP. The one embodiment of the system further supports the transport of AES/EBU, IEC958, S/PDIF, EIAJPC340/1201 and multi-channel LPCM data, as well as a generic serial audio stream. In addition, the start and stop of the audio stream is seamless and will not interfere with the video playback.

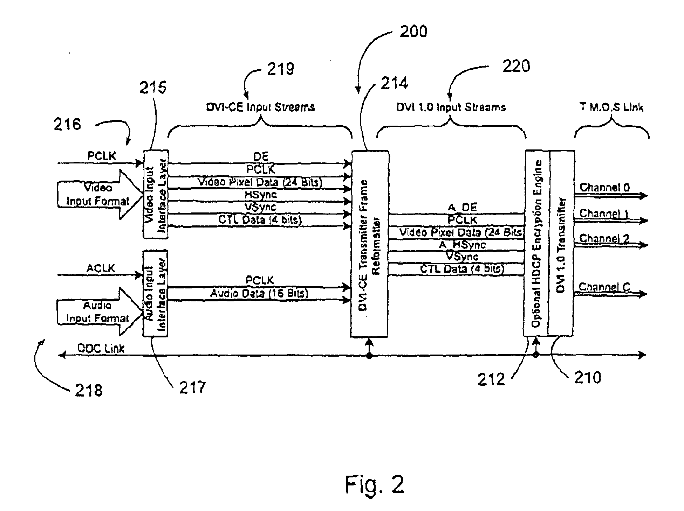

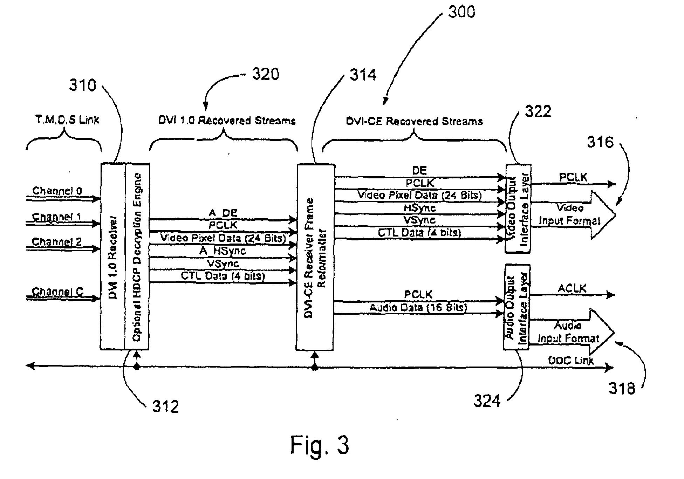

In one embodiment of operation of the present invention, a receiver indicates its capabilities via a DDC interface (illustrated in Figs. 2 and 3). The receiver is then notified of the audio configuration via DDC. Video parameters are transmitted over the video link for rapid update during resolution changes. In another embodiment, this information (audio configuration information may be transported in the audio pixel stream).

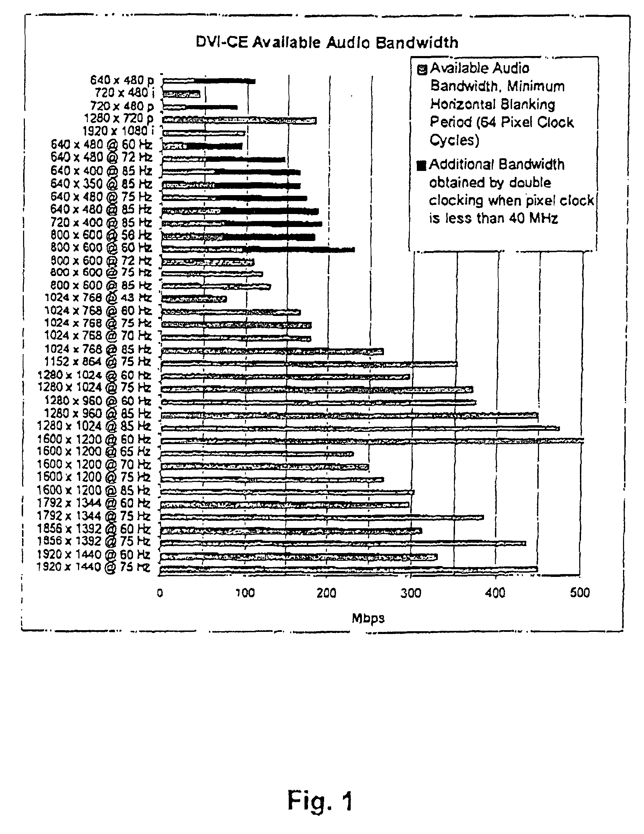

The amount of raw bandwidth available for audio transport over an interface varies with the display timing being used. Fig. 1 illustrates the amount of available audio bandwidth contemplated for use with one embodiment of an interface of the present invention. Available audio represents the bandwidth available on all current VESA and CEA specified timing formats. For a given timing format, the total audio throughput requirement is generally less than the numbers illustrated in Fig. 1. In one embodiment, a transport mechanism is defined that utilizes a blanking period for the transport of audio. Double clocking is permitted when the pixel clock is equal to or less than a fixed pixel clock rate, for example 40Mpps.

Devices (for example, transmitters, receivers, etc.) built in accordance with the present invention will generally be capable of transporting a minimum of about 43 Mbps of audio data. This is sufficient to support all current audio transport needs and provides significant cushion for future growth and other possible applications, including reduced blanking.

Fig. 2 illustrates a general system architecture of a transmitter, generally designated 200, in accordance with one embodiment of the present invention. Fig. 3 illustrates a general system architecture of a receiver, generally designated 300, in accordance with one embodiment of the present invention. At the core of the transmitter 200 of Fig. 2 is a DVI transmitter 210, optionally with an integrated HDCP encryption engine 212. In this embodiment, all inputs to the DVI transmitter 210 are compliant with the requirements of the DVI 1.0 specification, and more specifically with DVAAA specification. The system accepts as inputs, standard video data that is compliant with DVI 1.0 and DVAAA, and an audio data stream (see Fig. 2).

In dual link applications, a first link (link 0, for example) is used for audio data transmission. The audio input format may be any format that is negotiated between the transmitter 200 and receiver 300. Examples of audio input formats that may be used are PCM, SPDIF, or DVD Audio.

As illustrated in Fig. 2, a transmitter frame reformatter 214 accepts DVI-CE input streams 219 as input. In one embodiment, the input streams comprises the video channel 216 and the audio ( or auxiliary) channel 218 which are input to the video and audio input layers 215 and 217 respectively. The frame reformatter 214 combines the data into a frame analogous to the current video timing standards, generally designated 220. This frame is then output to the DVI transmitter 210. On the receive or sink side illustrated in Fig. 3, a DVI 1.0 receiver 310 (optionally, with an integrated or HDCP encryption engine 312) feeds recovered streams 320 into a receiver frame reformatter 314. The reformatter 314, communicating with video and audio output layers 322 and 324 respectively, splits out the audio and video data 318 and 316 respectively. Additional detail of both the transmitter and receiver frame reformatters is provided below.

In one embodiment, devices that serve as a source (a transmitter similar to transmitter 200 of Fig. 2, for example) to the interface of the present invention generally may have the following capabilities to be considered compliant with DVAAA, DVI and other relevant standards:

(1) Capable of time-multiplexing incoming video and audio data streams within a DVI compliant active data interval (for example, when Data Enable (alternatively referred to as "DE") is high);

(2) Capable of extending an active data interval into one or more blanking interval(s) by an amount sufficient to support an incoming audio data rate;

(3) Capable of reducing the duration of incoming horizontal and vertical syncs to maximize the time interval that is available for audio insertion;

(4) Support data rates up to about 165MHz over a single-link DVI 1.0 compliant interface;

(5) Support a mode of operation that is interoperable with DVI 1.0, DVAAA and HDCP 1.0 compliant sink devices;

(6) Support standard video timing formats such as VESA DMT and EIA/CEA-861 for example;

(7) Support transmission of I$^2$S and S/PDIF audio streams with serial bit rates of up to about 18.5Mbps;

(8) Capable of performing clock doubling when the source pixel clock operates at or below about fixed pixel clock rate, for example 40Mpps. (CEA 861 requires clock doubling for 480i [clock <25Mpps, for example]. This clock need not be doubled again. Clock doubling, however, is not necessarily a transmitter requirement);

(9) Generate Reed-Solomon error detection parity codes for the audio data stream; and

(10) Support YCrCb to RGB color space conversion. Devices that serve as a sink (a receiver similar to receiver 300 of Fig. 3 for example) to the interface of the present invention generally may have the following capabilities to be considered compliant with DVAAA and other relevant standards:

(1) Capable of de-multiplexing combined audio/video data streams;

(2) Capable of producing a standard timing video output signal as indicated by a received CE data stream;

(3) Capable of producing a serial audio output bit stream that supports bit rates from about 24kbps (1 Kilo-pixels-per second or kpps) up to about 15Mbps (i.e., 625kpps);

(4) Capable of reconstructing original horizontal and vertical syncs from received DVI-CE horizontal and vertical syncs and data;

(5) Compatible with received timing formats having a minimum horizontal blanking interval of about 64 pixels for all subsequent lines;

(6) Support data rates up to about 165MHz over a single-link DVI 1.0 compliant interface;

(7) Support a mode of operation that is interoperable with DVI 1.0, DVAAA and HDCP 1.0 compliant source devices.

(8) Capable of removing clock doubling from the video stream when the source pixel clock operates at or below about fixed pixel clock rate, for example 40Mpps if clock doubling is used. (This capability is found in the receiver);

(9) Support Reed-Solomon error correction for the audio data stream;

(10) Support RGB to YCrCb color space conversion; and

(11) The capabilities of the CE receiver will be made available via I2C in the receiver devices.

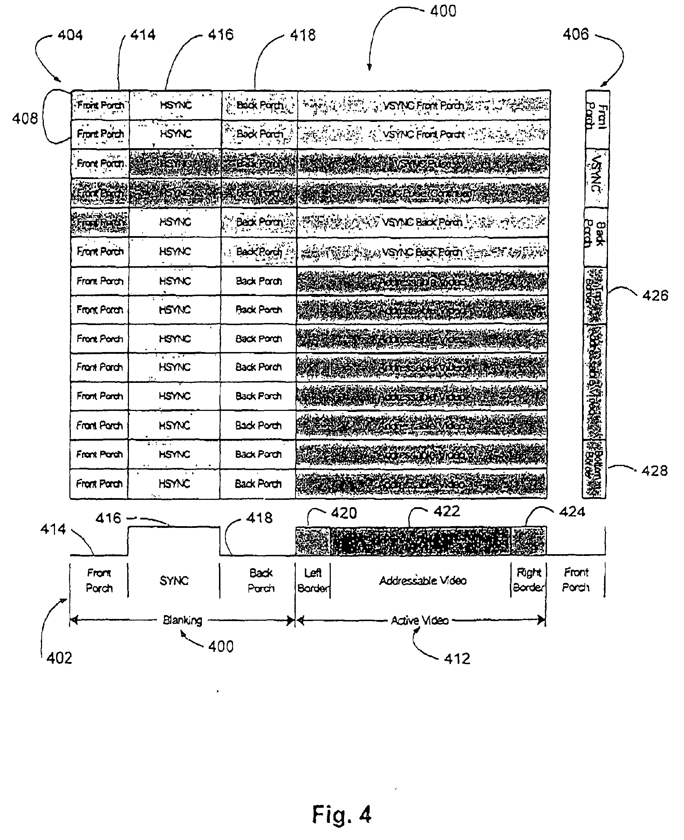

In one embodiment of the present invention, a standard video frame is one that is compatible with currently available displays. Fig. 4 illustrates a two-dimensional representation of a typical video input frame and generally designated 400. The names for the various parameters used in Fig. 4 are intended to be generally the same as used in the VESA timing standards. Fig. 4 is organized such that the HSYNC signal, generally designated 404, occurs on the left side of the diagram and the VSYNC signal, generally designated 406, occurs at the top. This is done to support the HDCP specification.

A video frame is built up from one or more horizontal lines 408. It should be appreciated that while 13 lines are illustrated more, or even less, lines are contemplated. The general format, generally designated 402, of a line 408 is illustrated at the bottom of Fig. 4. In this embodiment, each line 408 has two primary elements: a sync or blanking period 410 and active video 412. The sync or blanking period 410 is comprised of 3 elements: a front porch 414, a sync pulse 416, and a back porch 418. The sync pulse may be either a positive or negative pulse. The active video is made up of three elements as well: a left border 420, addressable video 422, and a right border 424.

In the illustrated embodiment, the lines are grouped to create a frame. Fig. 4 further illustrates a description of the various elements of the vertical frame. The left and right borders 420 and 424 are replaced with the top and bottom borders 426 and 428 respectively. As in the case of HSYNC, VSYNC may be either a positive or negative pulse. The actual sync pulse, as defined by the *VESA Monitor Timing Specification Version 1.0, Rev 0.8* incorporated herein by reference in its entirety, starts after the left border 420 of the first line in the region labeled as VSYNC and completes with the line immediately following the VSYNC region, just prior to the inactive video. The video stream is completed by stacking frames vertically, so that entire video stream is a continuum of vertically stacked lines. All the lines 408 are then transmitted, left to right, top to bottom in serial fashion. Frequently, the left, right, top, and bottom borders are length zero. This video frame is received as input by the transmitter, and replicated by the receiver's output.

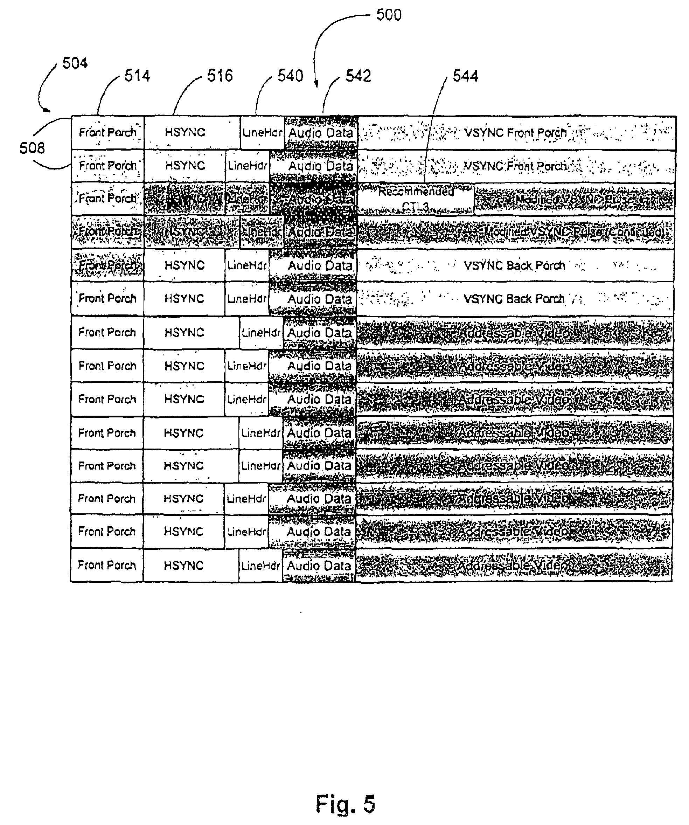

Fig. 5 illustrates a modified video frame definition generally designated 500 in accordance with one embodiment of the present invention. In the illustrated embodiment, the modified video frame includes HSYNC 504, lines 508, front porch 514, and VSYNC 516 similar to that illustrated in the video frame 400 of Fig. 4. The system of the present invention provides for the transmission of audio data and CTL3 and 544 as provided below, without changing the overall pixel clock rate of the prior system similar to that disclosed in Fig. 4. This is accomplished by reducing the blanking periods and using the bandwidth thus freed to transmit audio (or other auxiliary) data. All sync and control information will be transmitted either as original data or, transmitted over channel 0. Channel 0 is used during periods where line header 540 or audio data 542 is being transmitted. Information pertinent to each line of audio data, as well as any other information (for example color space, aspect ratio info, volume control, etc.) is transmitted in the line header.

In one embodiment of the present invention, the amount of audio data carried on each line 508 is variable. In another embodiment, the amount of video data is not variable for a given resolution. In yet another embodiment, for a given output display format, the number of lines transmitted over the DVI link is identical to the number of lines in the output addressable video. Furthermore, in still another embodiment, the number of addressable video pixels transmitted on each line is identical to the number of addressable pixels output from the DVI Receiver.

As provided above, an important aspect of a DVI transmitter is the block that accepts video data and audio data as inputs. In one embodiment, the video is input as standard 24 bit words, while the audio is fed in as 16 bit words. The frame reformatter (similar to the reformatter 214 in Fig. 2) inserts the audio data into the horizontal blank (and vertical blank at a similar position on the line) as described herein.

The audio data is packed into 16 bit audio pixels for transport over the communications channel or DVI link. Details about the content of the audio data are carried in the line headers 540. One method for packing the audio data for some specific cases is provided below.

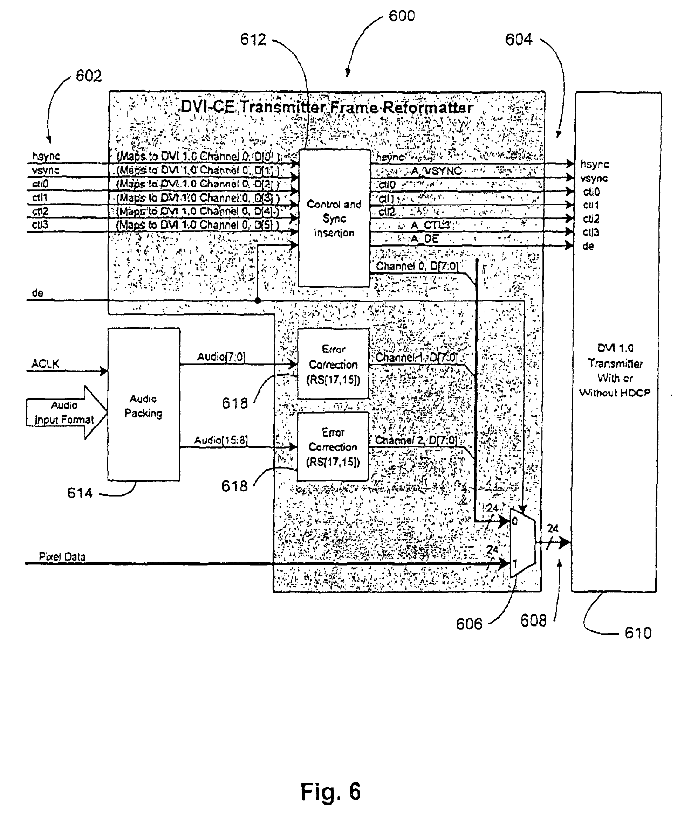

The display lines are adapted to output audio data and sync information. One embodiment of a transmitter reformatter (similar to 214 in Fig. 2 and generally designated 600) is illustrated in Fig. 6. Fig. 6 depicts the data inputs 602, outputs 604 and mux 606 used to supply the pixel data inputs 608 to the DVI 1.0 transmitter 610. As illustrated, the transmitter reformatter 600 includes a control and sync insertion device 612, audio packing device 614 and one or more error correction devices 618. The mapping for ctl and sync signals onto channel 0 for transmission during the period that audio line headers and audio data are being transmitted is also depicted.

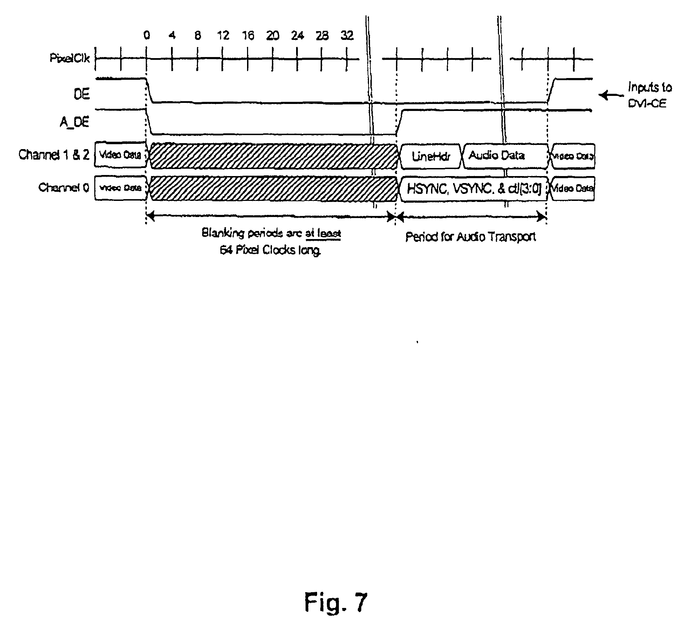

Fig. 7 illustrates an example of a timing diagram, demonstrating the timing that may be used for audio insertion in accordance with one embodiment of the present invention. The first signal, pixel clock, illustrates every 4th pixel clock transition. The next signal, DE, illustrates the standard input DE that is input to a typical video transmission system. The remaining lines A_DE, channel 1 and 2, and channel 0, illustrate the timing for signals that are output from the DVI transmitter frame reformatter (similar to the DVI transmitter frame reformatter 600 of Fig. 6) for transmission across a DVI 1.0 link.

A comparison of the DE input and A_DE output signals as illustrated in Fig. 7 may be used to understand where the audio bandwidth is created. Both signals have a falling transition at the same relative time, indicating the commencement of a blanking period. To end the blanking period, the A_DE signal transitions from low to high before the DE signal transitions. In one embodiment, audio data and line headers are transmitted during the time that A_DE is high and DE signal is low. During this period, the HYNC, VSYNC and ctl, signals are transmitted over channel 0 without modification. The mapping of the ctl and sync signals is illustrated in Fig. 6.

To meet the HDCP requirements during horizontal blanking periods, the A_DE signal is low for a period of at least about 64 pixel clock cycles. This enables the HDCP process "hdcpRekeyCipher" to be completed.

In one embodiment, all frames during which audio packets are transferred, have a modified VSYNC (alternatively referred to as "A_VSYNC") signal transmitted over the DVI link, thus indicating the CE (or DVI-CE) mode. In this embodiment, the presence of this modified VSYNC indicates that CE line headers are being transmitted, although not necessarily an audio stream.

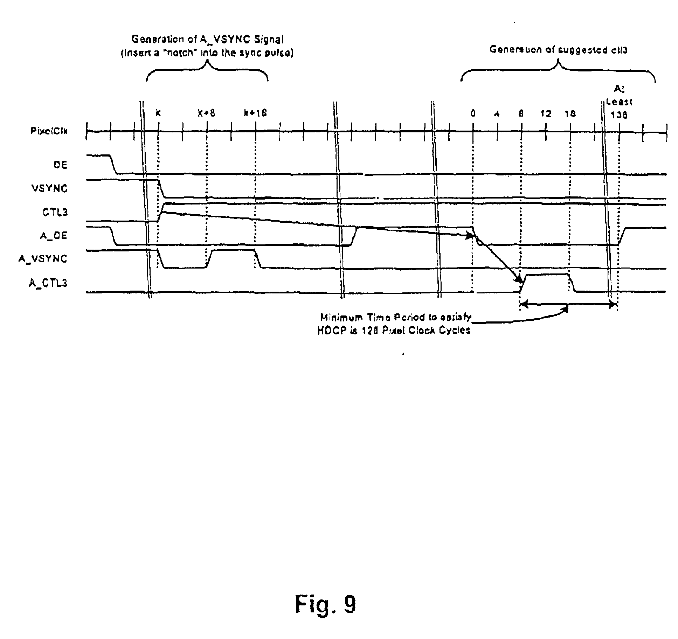

In one embodiment, an 8 clock cycle "notch" is inserted into the VSYNC signal to create the A_VSYNC signal. It occurs 8 clocks after the first edge of the VSYNC pulse. This is illustrated in Fig. 9 discussed below.

Another function of the transmit frame reformatter (similar to the transmitter frame reformatter 600 of Fig. 6) is that it adapts the ctl3 signal. In one embodiment, the reformatter adapts the ctl3 signal in such a manner as to be compliant with HDCP while transmitting an audio data (or auxiliary data) stream as provided below.

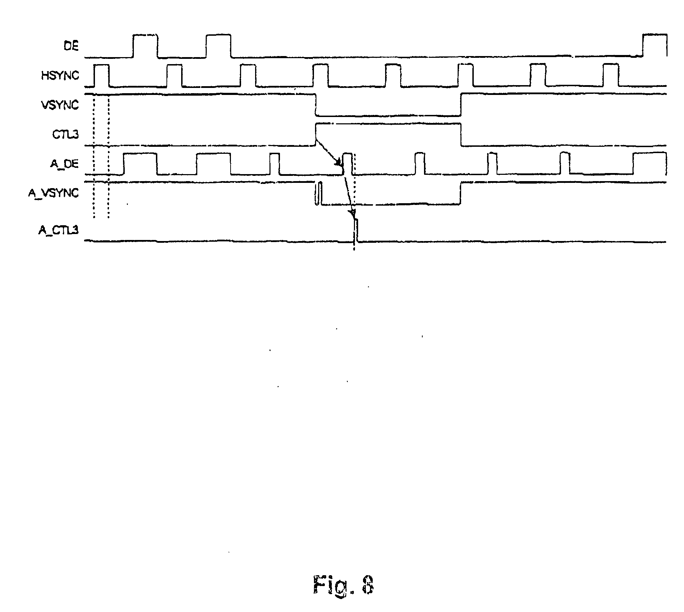

In one embodiment, the ctl3 input is first generated using VSYNC so that the ctl3 is a positive going pulse regardless of the polarity of VSYNC. The ctl3 signal is observed to identify a low to high transition. This indicates the need to generate A_CTL3 output for HDCP. This signal is generated in the first blanking period following the blanking period in which ctl3 transitioned. An example of the resultant timing is illustrated in Fig. 8.

Fig. 9 illustrates inserting a "notch" into the VSYNC signal to create the A_VSYNC signal as provided above. More specifically, Fig. 9 illustrates the timing details for an A_VSYNC definition, ctl3 timing and an actual A_CTL3 pulse. In one embodiment, the A_CTL3 pulse begins (i.e., goes high) 8 clock cycles after the start of the blanking period and lasts for 8 more clock cycles before going low again. The blanking period continues for at least 128 clock cycles to satisfy HDCP requirements.

As provided previously, when transmitting an audio stream, all lines have a line header, even if the audio data length is 0. Furthermore, all VSYNC-blanking periods have at least three lines. In one embodiment, there is at least one blanking period following the A_DE blanking period during which the ctl3 is transitioned in. Thus blanking period, in the minimum extreme, has a blanking period equal to the horizontal resolution of the display. Thus using A_CTL3 satisfies the HDCP requirements for frame key recalculation in all current VESA and digital CEA timing specifications.

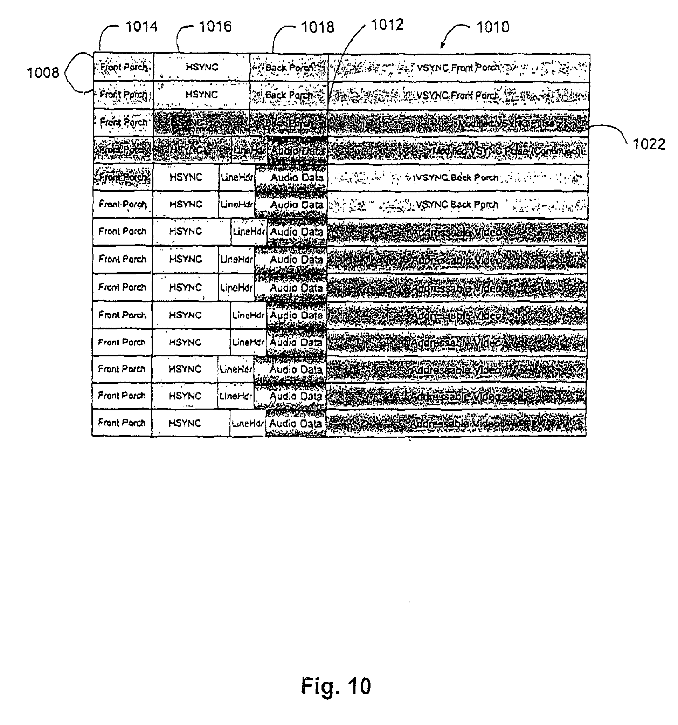

Fig. 10 illustrates frame timing diagram used when transitioning from a DVI 1.0 mode to a CE mode. This embodiment includes one or more lines 1008, front porch 1014, HSYNC signal 1016, back porch 1018 and the VSYNC signal, generally designated 1010. In one embodiment of the present invention, this timing is used in order to ensure that entry into and exit from CE mode is accomplished without visual artifacts. In this embodiment, the notch of Fig. 9 is applied to the VSYNC signal 1010, forming the modified VSYNC pulse 1022. On the display line immediately following the line with this notch, the first audio data packet 1012 is transmitted. In one embodiment, the location of the notched VSYNC includes one boundary condition. If the VSYNC is first transitioned 16 or more pixel clocks prior the end of a line, then the first audio packet is transmitted on the first line following the first VSYNC transition. If the VSYNC is first transitioned 15 or less pixel clocks prior to the end of a line, then the first audio packet is transmitted two lines after the first VSYNC transition.

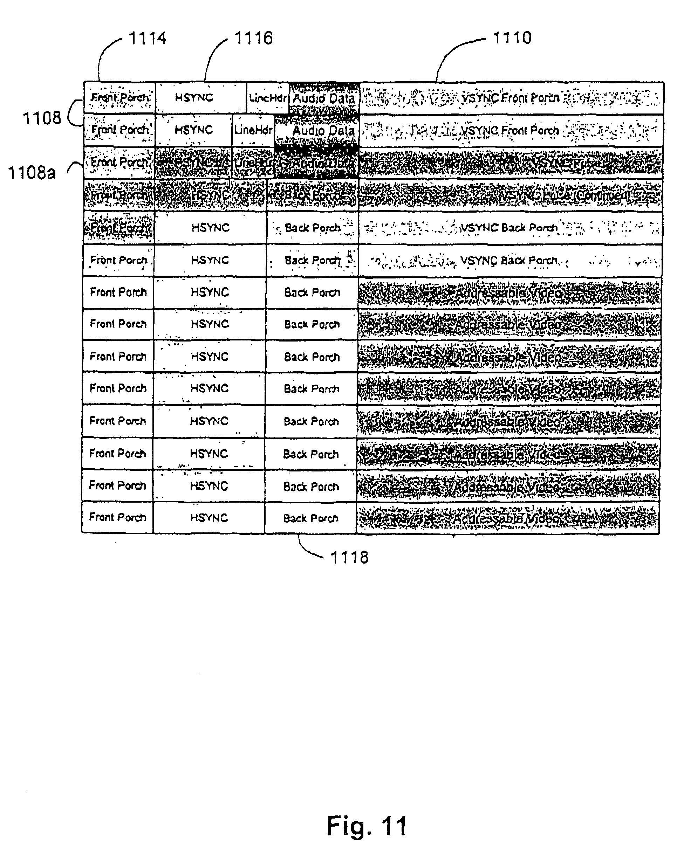

Fig. 11 illustrates a frame timing diagram used when transitioning from a CE mode to DVI 1.0 mode. Again, this frame includes one or more lines 1108, front porch 1114, HYSNC signal 1116, back porch and VSYNC signal generally designated 1110. When transitioning from DVI 1.0 to CE mode, the VSYNC notch is used as provided previously. In the illustrated frame, no VSYNC notch is present. The line on which the first transition of the VSYNC pulse occurs is the last line on which an audio packed is transmitted (line 1108(a) for example). In one embodiment, the location of the standard VSYNC is subject to one boundary condition. If the VSYNC is first transitioned 1 or more pixel clocks prior the end of a line, then the final audio packet is transmitted on the line with that transition. If the VSYNC is first transitioned on the boundary between two lines, then the final audio packet is transmitted on the line immediately following the transition.

In accordance with one embodiment, one element of a DVI receiver is the block that accepts the DVI compliant data stream as input and converts it into a 24-bit wide video stream and a 16-bit wide audio stream. In this embodiment, the audio data may be unpacked into an appropriate audio format. The formats used to unpack the audio data are negotiated prior to commencement of audio transmission. In one embodiment, the transmitters do not provide audio information that the receiver is not capable of decoding.

In one embodiment of the present invention, all audio data and line headers are protected using Reed-Solomon (alternatively referred to as "RS") coding. The RS block length is 34 pixel clocks in duration. Multiple blocks may be transmitted on a particular line provided that sufficient audio pixels are available. When operating in DVI transmission mode, every line contains an audio line header. This header is sent immediately after the A_DE signal transitions from low to high.

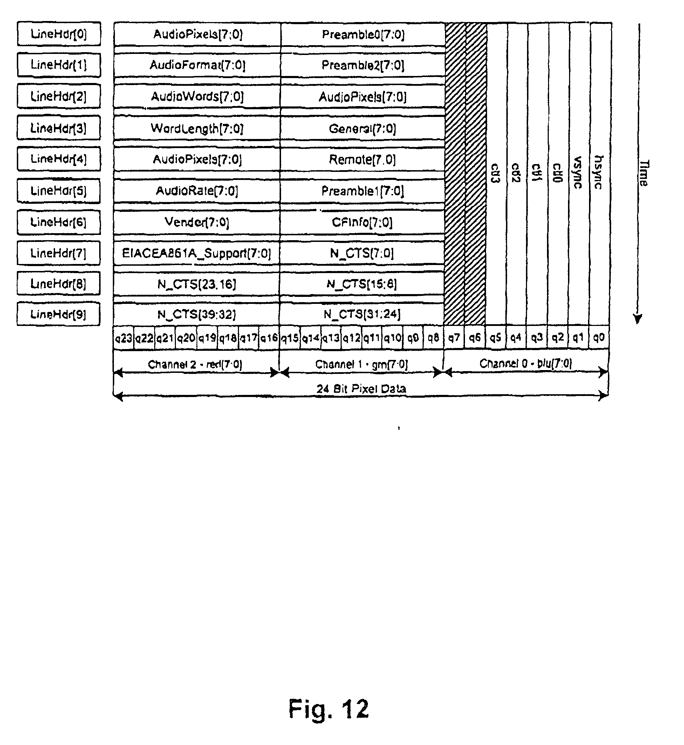

In this embodiment, the Line Header (LineHdr[9:0]) is a ten clock long period during which information relevant to the recovery of audio information and other information relevant to CE applications is transmitted. The timing of the transmission of this header is illustrated in Fig 12. The details about variables carried in this header are set forth in Table 1.

Table 1:

| Line Header Signal Definition | |
|---|---|
| **Signal** | **Description** |
| AudioWords[7:0] | This variable contains the number of audio words transmitted. In the case of PCM data, this number is the number of audio words transmitted in one of the PCM channels. |
| AudioPixels[7:0] | Specifies the number of pixel clocks that the audio packet will last. Includes the line header. If multiple audio blocks are transmitted, this number specifies the total aggregate length of all the blocks. This is used because a line header is transmitted only once per line. |
| AudioFormat[7:0] | This number indicates the format of the audio signal.<br>0x00　Generic Serial Audio Stream<br>0x01　Serial SPDIF stream with BI-Phase Mark stripped<br>0x02　DVD Audio<br>0x03　AC-3<br>0x04　DTS<br>0x05　AAC<br>0x06　ATRAC<br>0x07　MPEG<br>0x08　SACD<br>0x09 — 0xEF　Reserved<br>0xF0　PCM transmission, 1 audio channel<br>0xF1　PCM transmission, 2 audio channels<br>0xF2　PCM transmission, 3 audio channels<br>0xF3　PCM transmission, 4 audio channels<br>0xF4　PCM transmission, 5 audio channels<br>0xF5　PCM transmission, 6 audio channels<br>0xF6　PCM transmission, 7 audio channels<br>0xF7　PCM transmission, 8 audio channels<br>0xF8 — 0xFF　Reserved |
| AudioRate[7:0] | The audio data rate in kbps.<br>0x00 24<br>0x01 48<br>0x02 96 |

Table 1: (continued)

| Line Header Signal Definition | |
|---|---|
| **Signal** | **Description** |
| | 0x03 192 |
| | 0x04 — 0x0F      Reserved. Do not use. |
| | 0x10 22.05 |
| | 0x11 44.1 |
| | 0x12 88.2 |
| | 0x13 176.4 |
| | 0x14 — 0x1F      Reserved. Do not use. |
| | 0x20 32 |
| | 0x21 — 0xFE      Reserved. Do not use. |
| | 0xFF Unspecified |
| WordLength[7:0] | A number ranging from 1 to 255 specifying the length of the audio word. |
| Vender[7:0] | Vender Specific Command Channel. |
| **Signal** | **Description** |
| General[7:0] | General Purpose Parameters<br>Bit 0 →      Double clocking indicator bit<br>            0 → no double clocking<br>            1 → Double clocking<br>Bit 1 →      Audio Copying Allowed<br>            0 → No audio copies are permitted<br>            1 → Copies of the audio stream are permitted<br>Bit 7:2      Reserved. |
| EIACEA861A_Supp ort[7:0] | Data reserved for use by the EIA/CEA-861A specification. |
| CFInfo[7:0] | Cinema Frame Information (3-2 pull/down)<br>Bit 0 →     if = 1, top_field_first<br>Bit 1 →     if = 1, repeat_first_field<br>Bit 2 →     if = 1, picture_structure<br>Bit 3 →     if = 1, progressive_frame<br>Bit 4 →     if = 1, progressive_sequence<br>Bit 7:5 →      Reserved. |
| N_CTS[39:0] | The N and CTS data used for clock recovery with time-stamps.<br>Bit 19:0 → CTS<br>Bit 37:20 → N<br>Bit 38 → Audio Clock is coherency status bit<br>            0 → Audio clock is independent of pixel clock<br>            1 → Audio clock is coherent with pixel clock<br>Bit 39 → Reserved. |
| [Shaded] | All shaded bits in Fig. 12 are reserved and transmit as 0. |

In one embodiment of the present invention, the blanking period is shortened to accommodate the transmission of audio data. The general format and timing of this protocol has been described previously. A description of the relative positioning of the blanking periods or DE signals of the various stages of the communications system is described below.

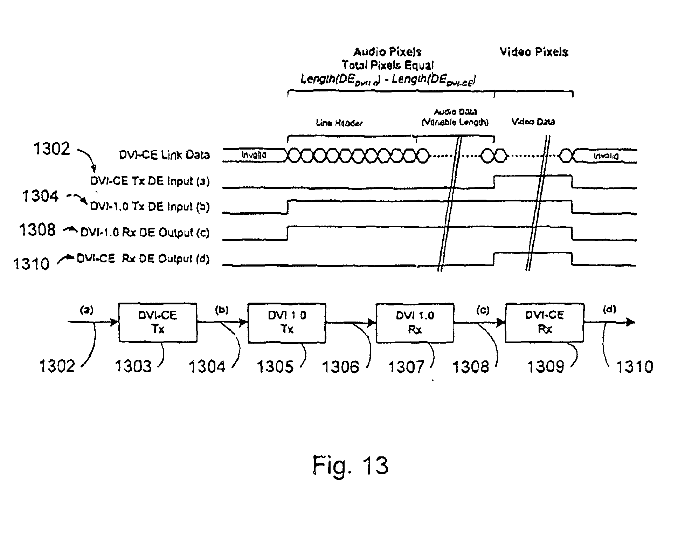

Fig. 13 summarizes the general characteristics of the timing at various stages in the communications link in accordance with one embodiment of the present invention. The input 1302 to the CE transmitter is illustrated. This input 1302 is the standard video DE that is used in previously known DVI 1.0 systems. This signal is ultimately reproduced on the receive side. The DVI-CE transmitter 1303 prepends the audio data onto the data bus and reduces the length of the blanking period generating DVI-CE transmitter input 1304. This data 1304 and the modified DE is fed into the DVI 1.0 transmitter 1305, and the DVI 1.0 transmitter transmits signal 1306 via the DVI link.

At the receive side, the process is reversed and the audio and video data streams are reconstructed. The DVI 1.0 receiver 1307 receives signal 1306, generating DVI 1.0 Rx DE output 1308. The DVI-CE receiver 1309, using output 1308 as an input, generates the DVI-CE Rx DE output 1310 (i.e., reconstructs the audio and video streams).

In one embodiment, the DVI Tx and Rx devices 1305 and 1307 are synchronized to the incoming data such that only the audio streams are buffered. No buffering of video stream (beyond normal pipelining) is generally required.

The EIA/CEA-861 Standard (A DTV Profile for Uncompressed High Speed Digital Interfaces) incorporated herein by reference in its entirety defines a plurality of video timings for a link. For example, the EIA/CEA-861 standard describes a 720x480i interface. To maintain the minimum DVI clock rate, the pixel clock should operate at twice the pixel rate and the pixel data should be transmitted two times in succession for each pixel to comply with the EIA/CEA-861 standard. In one embodiment, this feature is used to enable sufficient audio bandwidth for high quality audio applications.

CE devices may use this twice rate clock for the transmission of blanking and audio data. Unlike the video data (which is transmitted one value per two clocks), the blanking and audio data are transmitted one value per one clock.

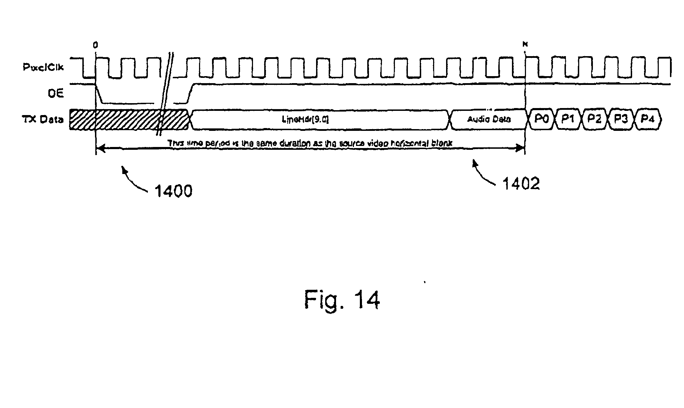

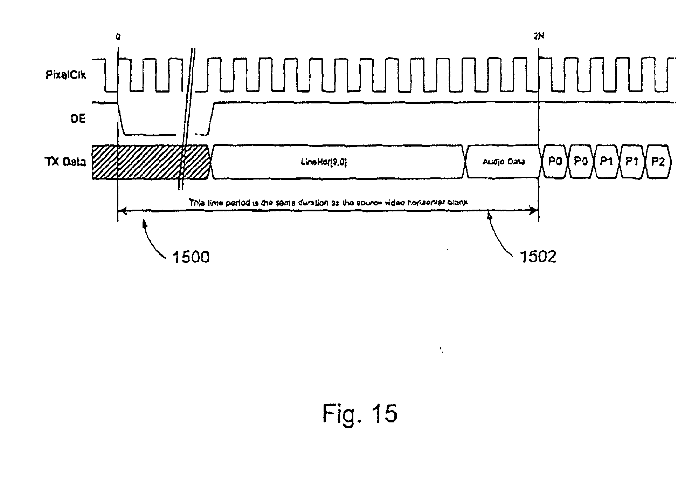

Fig. 14 illustrates a single clocking example of audio time division multiplexing. The example illustrated in Fig. 14 has been modified in Fig. 15 to demonstrate a twice pixel rate timing. Note that the length of the blanking period designated 1400 and 1500 in Figs. 14 and 15 respectively is unchanged in terms of clocks, but the audio duration (designated 1402 and 1502 in Figs. 14 and 15 respectively) has been extended in length from N in Fig. 14 to 2N in Fig. 15. Also, note that the video pixels (PO, P1, P2, etc.) are being transmitted two times in succession in Fig. 15.

It is optional for source devices in accordance with one embodiment of the present invention to be capable of double clocking for pixel clock rates at or below s fixed pixel rate, for example 40Mpps. It is not required that the double clocking be used, particularly when extra bandwidth is not needed for a particular audio application. In one embodiment, sink devices may be used to remove clock doubling.

In a CE mode, audio data is transferred over DVI link at the pixel clock rate. This mode provides means for transmitting audio data with jitter equal to the jitter on the pixel clock, using only digital circuitry.

Frequently, in consumer electronic devices equipped with an MPEG decoder (for example STB, DVD, etc.), the audio system clock (ACLK) is coherent with the pixel clock (PCLK). That is, ACLK has a data rate harmonically related to PCLK. ACLK is defined by the following equation:

$$ACLK = PCLK * \left( \frac{N}{CTS} \right) \qquad \text{Equation 1}$$

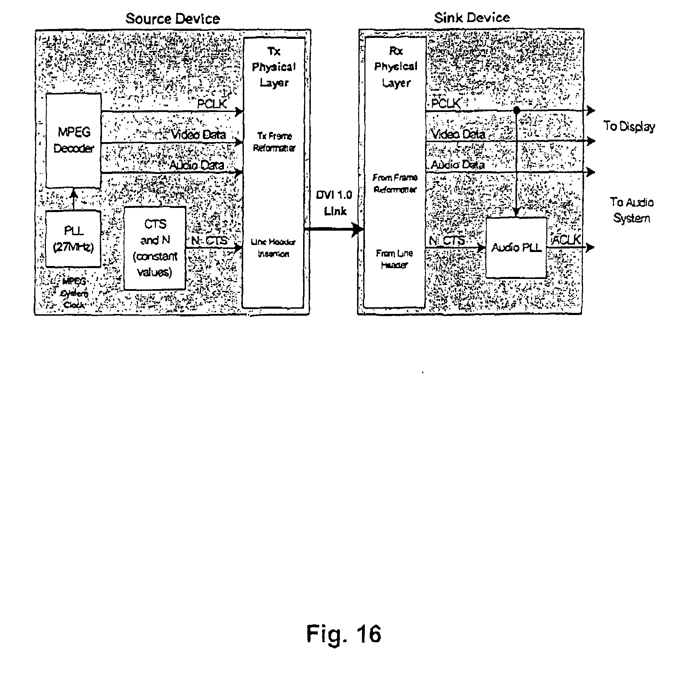

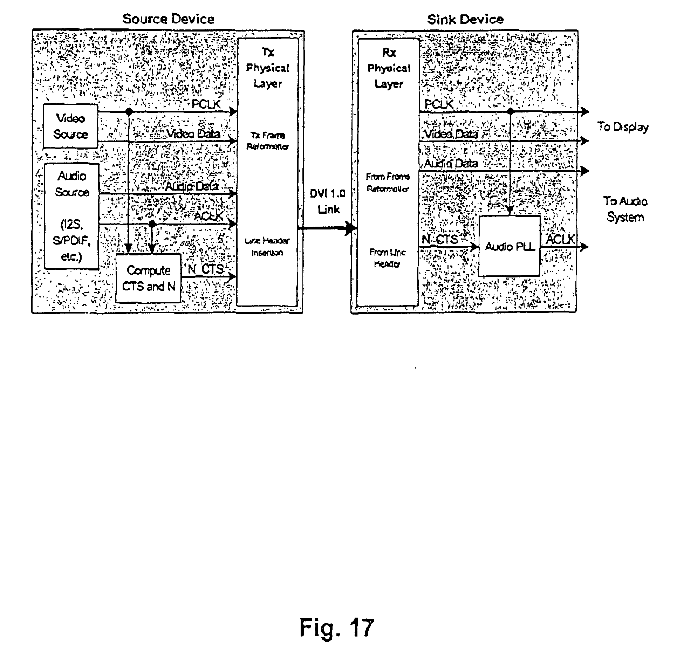

N and CTS are integers, PLCK is the DVI link pixel rate clock and ACLK is the audio system clock. For example, in S/PDIF, ACLK is the sub-frame clock and for I²S ACLK it is the sample rate clock. By using N and CTS as parameters for a digital PLL circuit, the receiver may reproduce the audio clock from the pixel clock. Example diagrams of coherent and non-coherent audio transmission systems one illustrated in Figs. 16 and 17, respectively. The audio transmission in Fig. 16 includes source and sink devices. Coherent audio data may be defined as having a data rate that is harmonically related to the pixel clock. In coherent audio data systems, the audio and video sub-systems share the same master clock, but may use fractional PLL multipliers and dividers to generate the respective desired frequencies. An example of such a system is a DVD player that uses a 27MHz clock source to drive both audio and video sub-systems.

Non-coherent audio data may be characterized by systems where the audio and video data comes from or is provided by separate sources. An example of this is a PC where both audio and video sub-systems contain their own clock sources. In such systems, the audio and video rates are non-harmonically related. Further, the absolute frequency accuracy and the low frequency wonder of each time-base is independent.

In coherent systems, the CTS and N values output by the source are constant. A bit is set in the line header to indicate this. Using this information, it is possible to recover ACLK with jitter equivalent to the jitter on PCLK.

In non-coherent systems, the N value represents the number of audio samples in the corresponding audio packet and the CTS value represents the number of pixel clocks cycles that the group of audio samples span. Further, in non-coherent systems, the CTS and N values may change from line to line. The value seen by the sink device may be digitally averaged to the jitter level required by the display device.

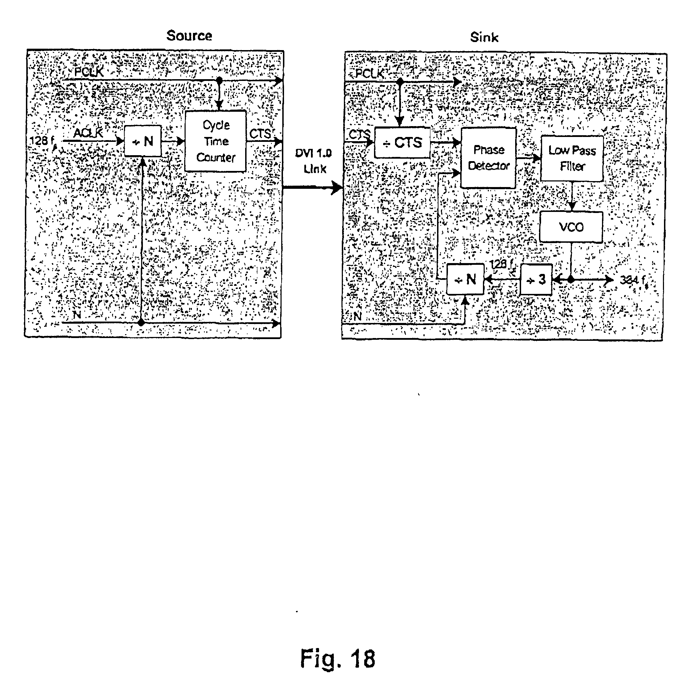

Fig. 18 illustrates an example of an audio clock recovery system generally designated that may be implemented to recover ACLK. In this illustrated example, the audio system clock or ACLK shown on the transmit or source side operates at 128x the sample rate ($128f_s$). The PLL system shown on the receive or sink side 1808 in Fig. 18 may be employed to recover the clock and generate a new system clock to be used for audio D/A conversion.

Restating Equation 1, for this example,

$$PCLK * \left( \frac{N}{CTS} \right) = 128 f_s \qquad \text{Equation 2}$$

Again, CTS and N are integer values. Appropriate values N are provided in Table 2 for common CE Pixel clock rates as defined in the CEA861 specification. The method for performing the selection of the CTS and N values is provided below.

Table 2:

| CTS and N values for 59.94Hz Refresh Rates | | | | | | | | | |
|---|---|---|---|---|---|---|---|---|---|
| Audio Clock Rate (kHz) | Pixel Clock = 25.175MHz | | | Pixel Clock = 27.000MHz | | | Pixel Clock = 74.175MHz | | |
| | CTS | N | PLL Ref (Hz) | CTS | N | PLL Ref (Hz) | CTS | N | PLL Ref (Hz) |
| 32 | 25175 | 4096 | 1000 | 27000 | 4096 | 1000 | 74175 | 4096 | 1000 |
| 48 | 25175 | 6144 | 1000 | 27000 | 6144 | 1000 | 74175 | 6144 | 1000 |
| 96 | 25175 | 12288 | 1000 | 27000 | 12288 | 1000 | 74175 | 12288 | 1000 |
| 192 | 25175 | 24576 | 1000 | 27000 | 24576 | 1000 | 74175 | 24576 | 1000 |
| 44.1 | 27972 | 6271.950 | 900.007 | 30000 | 6272 | 900 | 82416 | 6271.949 | 900.007 |
| 88.2 | 27972 | 12543.900 | 900.007 | 30000 | 12544 | 900 | 82416 | 12543.899 | 900.007 |
| 176.4 | 27972 | 25087.801 | 900.007 | 30000 | 25088 | 900 | 82416 | 25087.797 | 900.007 |

The source device in Fig. 18 defines a Cycle Time Counter. In this example, the cycle time ("CTS") is defined as the number of pixel clock periods that transpire during the period of $N/(128 f_s)$. The other parameter used for timing recovery, N, typically will not change for a given $f_s$ and PCLK. In non-coherent systems, it is possible that the value of CTS will vary from line to line.

The CTS and N values are then transmitted over the link in the line header. The receiver has a PLL with a variable M divider. The CTS divider reproduces the cycle time and outputs it as a reference for the PLL.

To maximize the jitter performance of the receive PLL, it is desirable (but not required) to have the audio clock coherent with the pixel clock. In this embodiment, the CTS value remains constant and the receive PLL may recover the audio system PLL jitter equal to the jitter on PCLK. Additional advanced audio clock conditioning circuitry may be employed in receiver systems to further reduce jitter in the audio clock.

One embodiment of the CE mode uses an I2C interface for some basic configuration and control functions. The following Table 3 specifies select parameters for the primary link HDCP and DVI-CE Port (I2C device address).

Table 3:

| Primary Link HDCP and DVI-CE Port (I2C device address 0x??) | | | |
|---|---|---|---|
| **Offset (hex)** | **Name** | **Rd/ Wr** | **Function** |
| 0x00 | Status | Rd | Provides status info about the receiver<br>Bit 0:    1 → Audio PLL is locked<br>0 → Audio PLL is not locked |

Table 3: (continued)

| Offset (hex) | Name | Rd/ Wr | Function |
|---|---|---|---|
| | | | Bit 1-7     Reserved. Always 0. |
| 0x01 | AudioFormats | Rd | Summarizes the audio formats supported on DVI-CE Silicon. In cases where downstream devices can support certain formats, it is anticipated that DI-EXT will be used to specify these capabilities.<br>Bit 0:     1 → Generic stream supported<br>0 → [Not Allowed for DVI-CE Devices]<br>Bit 1     1 → PCM Supported<br>0 → [Not Allowed for DVI-CE Devices]<br>Bit 2     1 → SPDIF Supported<br>0 → [Not Allowed for DVI-CE Devices]<br>Bit 3:     1 → DVD Audio Supported<br>0 → DVD Audio Not Supported<br>Bit 4-7     Reserved. Always 0. |
| 0x02 | PCMChannels | Rd | Indicates the number of PCM channels that the receiver chip can support. This number is at least 2, but not more than 16 |
| 0x03-0x1F | Rsvd | Rd | Reserved. Read as zero. |
| 0x10 | AbufLen | Rd | Audio Buffer length. This specifies the length of the audio buffer in terms of 16 bit words. Thus, if this reads as 64, then the buffer length is 1024 bits for each audio link. |
| 0x11-0xFF | Rsvd | Rd | Reserved. Read as zero. |

**Primary Link HDCP and DVI-CE Port (I²C device address 0x??)**

In an embodiment of the present invention, transitions in and out of DVI-CE mode are transparent and cause no abnormalities to appear on the display image. Digital audio transmissions are sensitive to bit errors in the transmitted data stream, particularly in cases of compressed data. Because of this, error correction is employed in one embodiment of the CE mode. Inside of the frame reformatter are two error correction coding (alternatively referred to as "ECC") blocks (See Fig. 6). Each of the EEC blocks operates on a TMDS channel. The output of these blocks are inserted into the video stream as described.

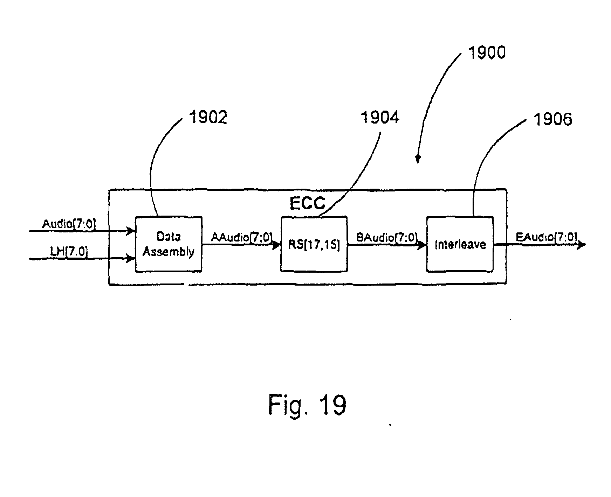

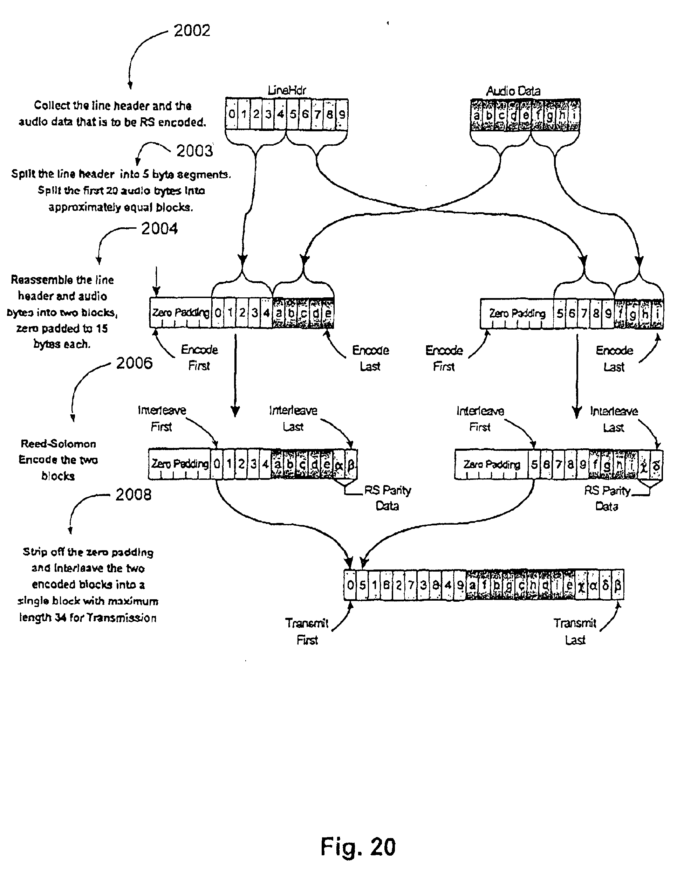

The stages in the ECC block, generally designated 1900, are illustrated in Fig. 19. An example of the process has been provided in Fig. 20. In this process, the data (audio and line header) is assembled using an assembly device 1902, RS encoded into 17-byte blocks for example, using an encoding device 1904 and then interleaved using an interleave device 1906 to form audio blocks with lengths up to 34 bytes for example. Details of each step in the process using the ECC block are provided below. While 17-byte RS blocks and audio blocks of 34 bytes are discusses, other embodiments, having different sized RS and audio blocks are contemplated. Additionally, interleaving may or may not be employed.

As illustrated in Fig. 20, the first stage of the ECC block is data assembly as illustrated in step 2002. In this stage, the audio and line header data are collected. Next, the line header is split into two 5 byte blocks, (blocks 0-5 and 6-9 for example) as illustrated in step 2003. The audio data is also split into equal portions (blocks a-e and f-i for example). There are two special cases to consider. First, if there is an odd number of audio bytes to be transported in a particular audio block, the extra byte will be incorporated into the first block fed into the interleaver. (This case is illustrated in Fig. 20). The second special case occurs when more than 20 audio bytes are to be transmitted on a particular line. In this case, the first 20 bytes will be transmitted in the first block. Since only one line header is transmitted on each line, each remaining block may contain up to 30 audio bytes. These are assembled sequentially until all audio data has been assembled.

Next, each half of the audio data (blocks a-e and f-i) is appended to the line header (blocks 0-5 and 6-9) as illustrated in step 2004. Each block is padded with zeros to create blocks that are each 15 bytes in length.

The two blocks are RS encoded as generally illustrated in step 2006. The first RS block transmitted in a line may have from 0 to 20 audio bytes, for example. Additional blocks on the same line may have from 1 to 30 audio bytes, for example.

In one embodiment, a pixel error rate of $10^{-9}$ is required to comply with the DVI 1.0 standard. However, in practice, error rates may be higher ($10^{-7}$ for example) and still produce acceptable video quality. Therefore, the audio channel should be able to cope with rates on the order of about $10^{-7}$ or lower. Data errors that should be repaired generally occur in bursts 2 pixel periods or less, and are spaced more than 34 pixel periods apart.

In one embodiment illustrated in Fig. 20, a Reed-Solomon [17,15] rate 0.88 code capable of correcting one symbol error per block is used to protect the audio stream as illustrated in step 2006. This method transports 15 symbols per code block. Thus, two code blocks are constructed for each line that audio data is transported on.

The code is defined using Galois Field ($2^8$) (GF[256]) with n=17, as 17 is a prime factor of 255. The data is then interleaved (described below) as illustrated in step 2008 to ensure that if two sequential errors occur, then each error appears in a different block of length 17.

The following parameters and abbreviations may be used in the RS code.

$n \rightarrow$ block length in symbols

$k \rightarrow$ payload length in symbols

$RS[n,k] \rightarrow$ Short hand for Reed Solomon code

$t \rightarrow$ Number of symbol errors that can be corrected in a block

$m \rightarrow$ Number of bits in a Reed-Solomon symbol.

The relative relationship of the sizes of these parameters is:

$$0 < k < n < 2^m \qquad \text{Equation 3}$$

The number of errors, $t$, that can be corrected are the integer part of the following relationship:

$$t = \left\lfloor \frac{n-k}{2} \right\rfloor \qquad \text{Equation 4}$$

The primitive polynomial used to generate the Galois extension field elements is defined as:

$$1 + X^2 + X^3 + X^4 + X^8 \qquad \text{Equation 5}$$

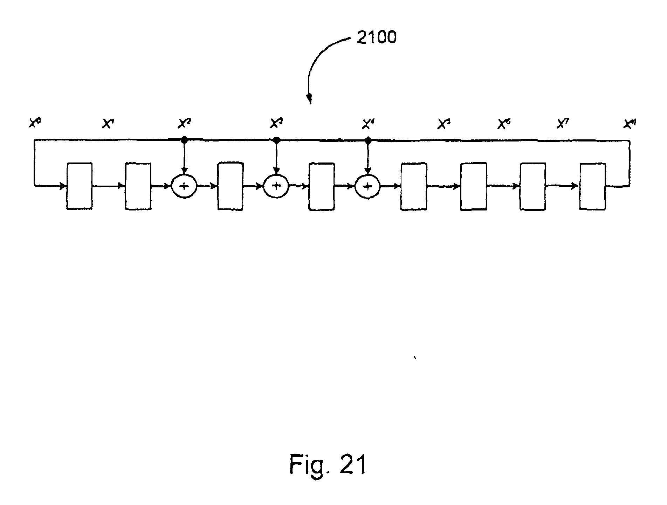

The extension field elements may be represented by the contents of a binary linear feedback shift register (alternatively referred to as LFSR), formed from the previous primitive polynomial. One embodiment of an LFSR, generally designated 2100 is illustrated in Fig. 21.

The mapping field elements used in the encoder polynomial and hardware are provided in Table 4. These have been defined in terms of basis elements for GF($2^8$) with $f(X) = 1 + X^2 + X^3 + X^4 + X^8$.

Table 4:

| Mapping Field Elements Used in CE Encoder | |
|---|---|
| Field Elements | Basis Elements (LSB: MSB) |
| $\alpha^0$ | 1000 0000 |
| $\alpha^1$ | 0100 0000 |
| $\alpha^2$ | 0010 0000 |

Table 4: (continued)

| Mapping Field Elements Used in CE Encoder | |
| --- | --- |
| Field Elements | Basis Elements (LSB: MSB) |
| $\alpha^3$ | 0001 0000 |
| $\alpha^{26} = \alpha^1 + \alpha^2$ | 0110 0000 |

Assuming that $j_0 = t = 1$, the Reed-Solomon generator polynomial may be computed from the generic form as follows:

$$g(X) = \prod_{i=0}^{i=2t-1}\left(X + \alpha^{i+j_0}\right)$$
$$= \left(X + \alpha\right)\left(X + \alpha^2\right) \qquad \text{Equation 6}$$
$$= X^2 + \alpha X + \alpha^2 X + \alpha^3$$
$$= X^2 + \alpha^{26} X + \alpha^3$$

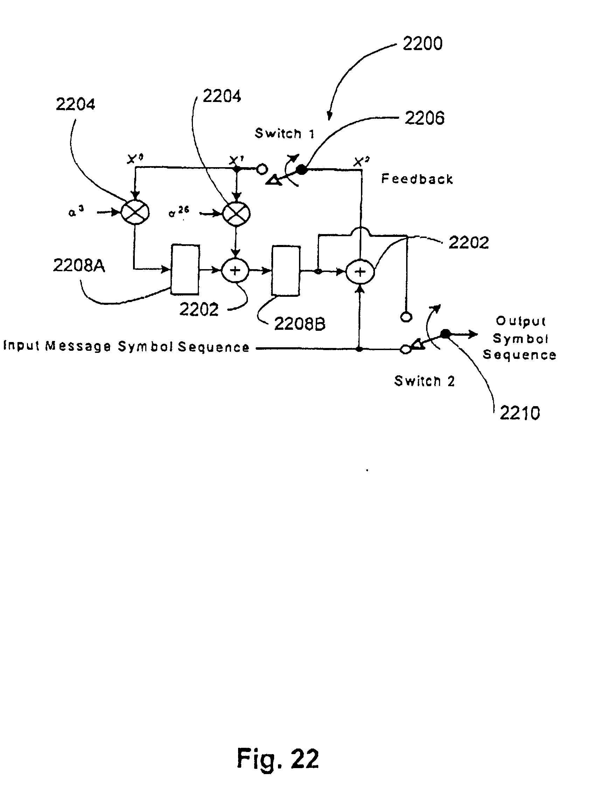

The encoder hardware produced by this equation is illustrated in Fig. 22 and generally designated 2200. In Fig. 22, the symbol $\oplus$, generally designated 2202, represents an adder that adds two elements from GF($2^m$). Similarly, the symbol $\otimes$, generally designated 2204, represents a multiplier that multiplies a field element from GF($2^8$) with a fixed element from the same field.

One embodiment of the encoding process is provided below:

For the first k cycles:

Switch 1 2206 is closed to enable shifting the message symbols into the ($n$ - $k$)-stage shift register (in one embodiment a two symbol shift register, designated 2208A and 2208B, is illustrated. Switch 2 2210 is in the down position to allow simultaneous transfer of the message symbols directly to an output register.

After k cycles:

The original message has been transferred to the output register.

Switch 1 2206 is opened. Switch 2 2210 is moved to the up position.

For the remaining (n-k) clock cycles:

The parity symbols contained in the shift register 2208A and 2208B to the output register. In this example, the total number of clock cycles is equal to n. The contents of the output register is the codeword polynomial $X^{n-k}m(X) + p(X)$, where p(X) represents the parity symbols and m(X) the message symbols in polynomial form.

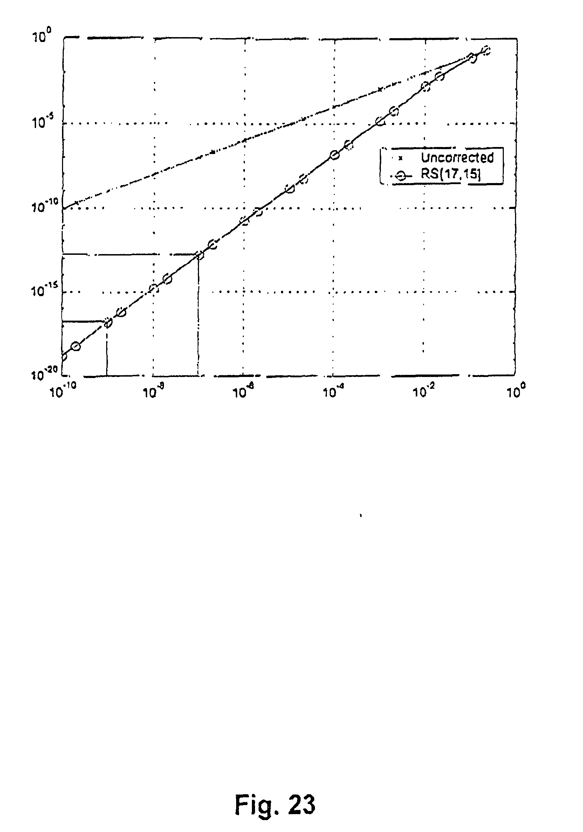

The performance of the error correction code is illustrated by the graphs illustrated in Fig. 23. The figure was generated using the following equation:

$$P_E \cong \frac{1}{2^m - 1} \sum_{j=t+1}^{2^m-1} j \binom{2^m - 1}{j} p^j (1 - p)^{2^m - 1 - j} \qquad \text{Equation 7}$$

In this equation, $p$ is the TMDS channel symbol error probability, $m$ is the number of bits in a RS symbol, and $t$ is the number of symbol errors that can be corrected.

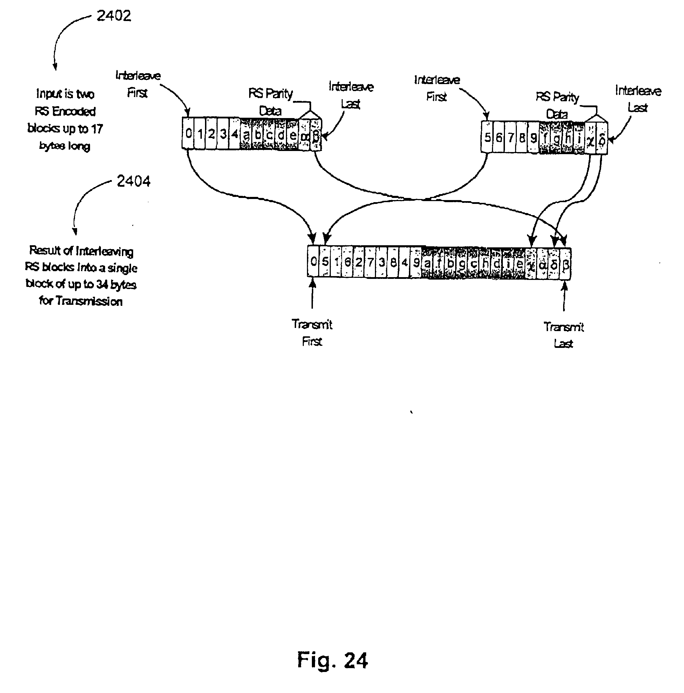

In one embodiment of the present invention, the two encoded blocks of Fig. 20 are interleaved before transmitting audio data from the CE transmitter as provided previously. Fig. 24 further illustrates interleaving two RS blocks. Such interleaving may include inputting two RS blocks up to 17 bytes long, as illustrated in step 2402, to form a complete interleaved block of 34 symbols 15 is illustrated in Fig. 24. In Fig. 24 (and Fig. 20), the line header (8 bytes) is represented by a light shade and numbers 0-4 and 5-9, and the audio data is represented by a dark shade and letters a-e and f-i. The party data is represented by symbols X, $\alpha$, $\delta$, and $\beta$. The interleaving includes taking the first line header bit from the first block, then the first line header bit from the second block, etc. In this manner, a single block (of up to 34 bytes) consisting of alternating bytes the first and second blocks as illustrated in step 2404.

In one embodiment, the CE receiver performs RS error correction of the recovered data stream and reconstructs the original 8 bit Audio[7:0] and the line header data. The final output is a serial or parallel audio stream compatible with the receive system.

In one embodiment, CE devices are capable of transporting a single serial stream (i.e. Generic or DVD-AUDIO). One method for transporting the stream includes dividing the serial stream into 16 bit segments. These segments are then converted into 16-bit words, and finally the words are fed into the frame re-formatter for transmission. The inverse function is performed at the receive side.

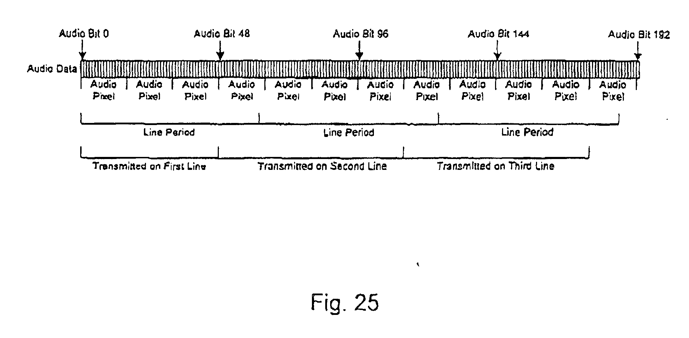

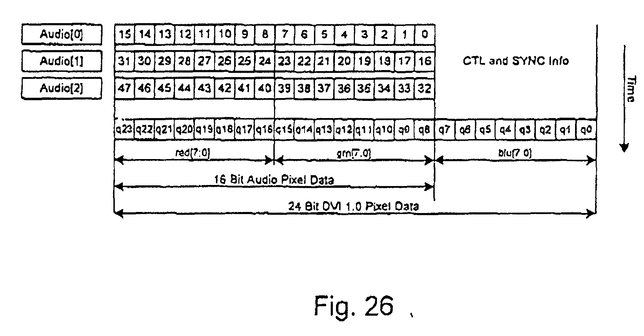

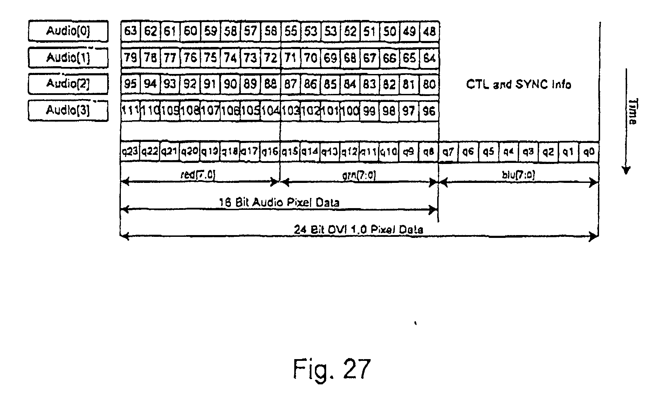

As an example, Fig. 25 depicts an audio application in which the serial data is communicated across the link with a rate of 62 audio bits per video line. Fig. 25 illustrates how the data is partitioned into audio pixels. Then the audio data is transmitted over the link as various 16 bit words become available. Examples of the data mapping of serial audio streams can be found in Figs. 26 and Fig. 27.

For this data mapping, the following parameters may be set:

WordLength =16 (i.e., the word size is 16 bits)

AudioWords = 3 for the case illustrated in Fig. 26 and 4 for the case illustrated in Fig. 27

AudioFormat = 0x00 (Generic serial stream transmission)

Note that for the generic stream, WordLength may be set to any value from 1 to 255, for example.

Fig. 26 illustrates three transmitted audio pixels and Fig. 27 illustrates four transmitted audio pixels, thus demonstrating that the number of audio pixels is variable from line to line. If no audio data is transmitted, AudioWords is set to 0. The audio format (AudioFormat) in this case would is set to 0. The AudioFormat Variable is located in the FrameHdr portion of the transmission.

In one embodiment of the present invention, the data depicted in Fig. 26 and Fig. 27 is then fed into the Reed-Solomon Error Correction blocks prior to integration with the video data stream.

In one embodiment, a CE device is capable of transporting a SPDIF data stream. Specifically, for maximum efficiency, Biphase mark encoding is removed from bits 4-31. The data transmitted during the preamble is converted to standard bits according to the conversion illustrated in Table 7. On the receive side, the preamble is reconstructed according to the rules set forth by the SPDIF and related standards.

Table 5:

| SPDIF to CE Preamble Mapping | | | |
|---|---|---|---|
| **Prea mble Name** | **SPDIF (Shows ½ bits)** | | **DVI-CE (Shows full bits)** |
| | **La st cell "0"** | **Las t Cell "1"** | **Transmits as** |
| B | 11 101000 | 000 10111 | 1000 |
| M | 11 100010 | 000 11101 | 0010 |
| W | 11 100100 | 000 11011 | 0100 |

Once the biphase mark has been removed and the preamble coding replaced with the bits depicted in Table 5, the SPDIF data may be treated as words of length 32. To simplify the reconstruction process at the receiver, a CE word corresponds exactly to a SPDIF sub-frame. This data is divided into 16 bit segments and are fed into the frame re-formatter for transmission. The inverse function is performed at the receive side.

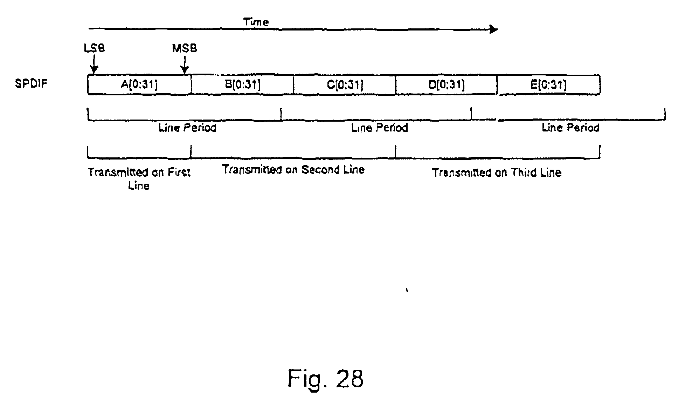

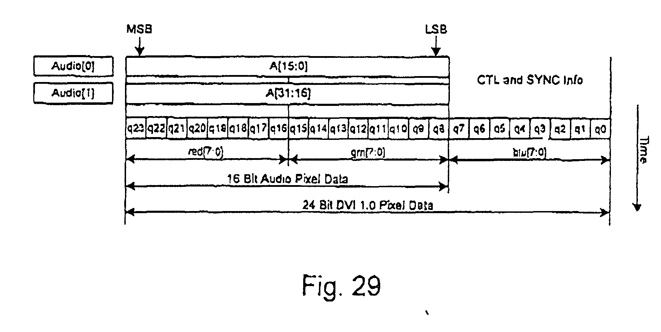

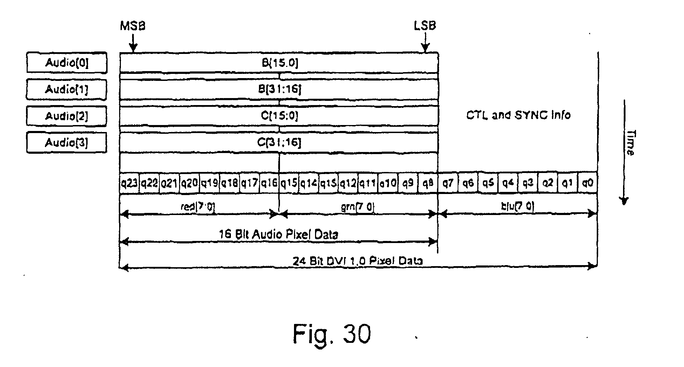

As an example, Fig. 28 illustrates an audio application in which SPDIF data is input into a CE device. in this example, the width of the data samples is 32 bits. Fig. 28 illustrates how the data is partitioned into audio pixels. Then the audio data is then mapped into 16-bit audio pixels as illustrated in Fig. 29 and Fig. 30.

Fig. 29 illustrated how one SPDIF subframe is packed into two audio pixels. Similarly, Fig. 30 illustrates how SPDIF subframes are packed into four audio pixels. Figs. 29 and 30 illustrate that the number of audio pixels is variable from line to line.

In this example, the following parameter values are set:

WordLength =32 (i.e. the word size is 32 bits)

AudioWords = 1 for the case in Fig. 29 and 2 for the case in Fig. 30

AudioFormat = 0x01 (SPDIF transmission)

The data illustrated in Figs. 29 and Fig. 30 is then fed into Reed-Solomon error correction blocks prior to integration with the video data stream.

In another embodiment, a CE device is capable of transporting one or more PCM data links. Specifically, the PCM data is treated as words that are the length of the audio sample. The data is organized so that one sample for each channel at a given time is transmitted before the next time instant of channel data is transmitted. This data is divided into 16 bit segments. These segments are then converted into 16-bit words, and finally the words are fed into the frame re-formatter for transmission. The inverse function is performed at the receive side.

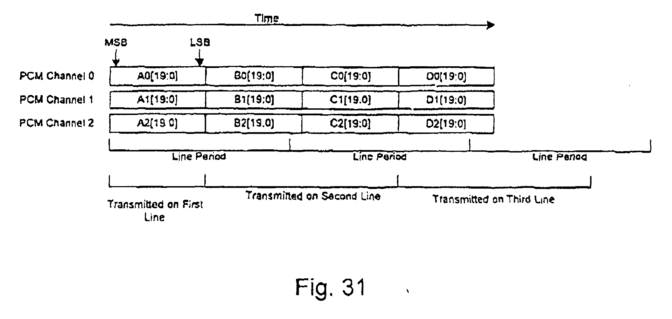

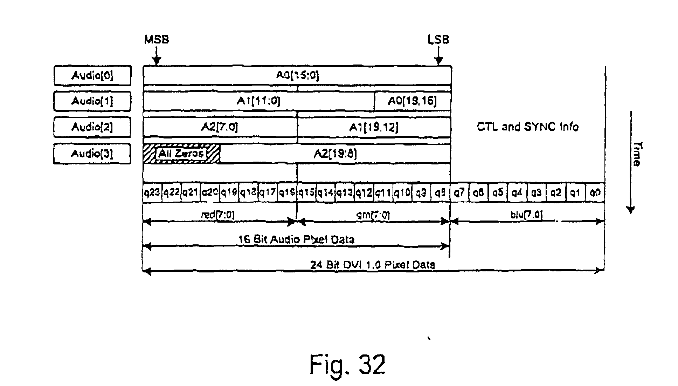

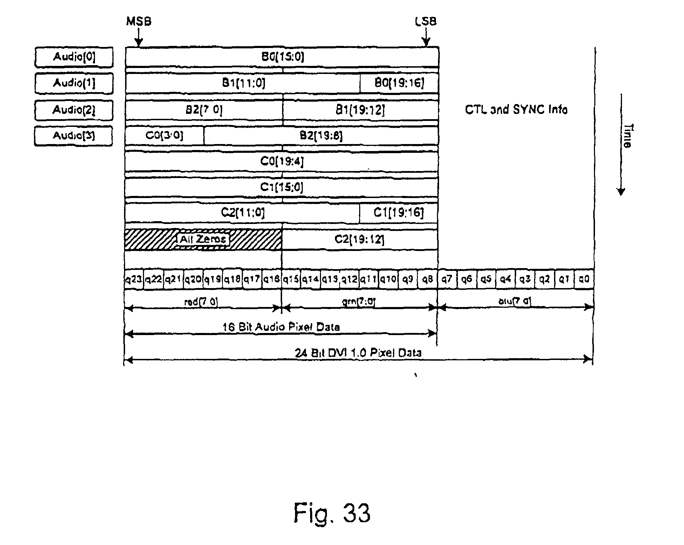

As an example, Fig. 31 illustrates an audio application in which PCM data is being input into the DVI-CE device. The data may be fed in serially or in parallel, the choice is determined by the application. The width of the data samples in this example is 20 bits, and three channels are being transmitted. Fig. 3 illustrates how the data may be partitioned into audio pixels. Then the audio data will then be mapped into 16-bit audio pixels as shown in Figs. 32 and 33.

Fig. 32 illustrates how a one time sample for the three channels are packed into the audio stream. Similarly, Fig. 33 illustrates how two time samples for the three channels are packed into the audio stream. All three channels are transmitted for each time sample. These figures illustrate that the number of audio pixels is variable line to line.

In this example, the following parameter values are set:

WordLength =20 (i.e. the sample size for each channel is 20)

AudioWords = 1 for the case in Fig. 32 and 2 for the case in Fig. 33

AudioFormat = 0xF2 (PCM transmission, 3 audio channels)

The data illustrated in Figs. 32 and 33 is then fed into Reed-Solomon error correction blocks prior to integration with the video data stream. Note that for a serial input, the input MSB/LSB relationship for this example is reversed from the SPDIF example discussed above.

Many modifications and variations of the present invention are possible in light of the above teachings. Thus, it is to be understood that, within the scope of the appended claims, the invention may be practiced otherwise than as described hereinabove.

**Claims**

1. A method of transporting video and audio data comprising:

receiving, by a first transmitter, a video data stream;

receiving, by said first transmitter, an audio data stream;

generating, by said first transmitter, a composite data stream from said audio and video data streams;

communicating, by said first transmitter, said composite data stream to a second transmitter; and

communicating, by said second transmitter, said composite data stream to a remote receiver.

2. The method of Claim 1, including communicating said composite data stream to said remote receiver over a digital communications link.

3. The method of Claim 1, wherein said video data stream is a data enable signal.

4. The method of Claim 1, wherein said audio data stream is prepended to said video data stream.

5. The method of Claim 1, further comprising reconstructing said video and audio data streams from said composite stream.

6. A method of communicating data over a communications link comprising shortening a blanking period in the data to accommodate auxiliary data.

7. The method of Claim 6, comprising modifying at least one HYSNC signal in the data to accommodate said auxiliary data.

8. The method of Claim 6, wherein said auxiliary data is audio data.

9. The method of Claim 6, wherein said communications link is a digital communications link.

10. The method of Claim 6, comprising modifying a VYSNC signal in all frames in which the auxiliary data is to be transmitted.

11. The method of Claim 10, further comprising inserting a notch in all said VYSNC signals.

12. The method of Claim 11, wherein inserting said notch includes inserting an 8 clock cycle pulse into said VYSNC signals.

13. The method of Claim 12, further wherein said notch is inserted into said VYSNC signals 8 clock pulses after a first edge of said VYSNC signals.

14. The method of Claim 10, further comprising adapting at least one control signal to be compliant with a content protection standard.

15. The method of Claim 14, wherein said at least one control signal is adapted to be compliant with said content protection standard while transmitting said auxiliary data.

16. The method of Claim 14, wherein said control signal is ctl3.

17. The method of Claim 14, wherein said content protection standard comprises a High-bandwidth Digital Content Protection standard.

18. The method of Claim 14, wherein adapting said control signal comprises generating a ctl3 input using at least one VSYNC signal.

19. The method of Claim 18, further comprising ensuring that the ctl3 input is a positive going pulse.

20. A system for communicating data and auxiliary data over a video communications link, comprising:

   a reformatter adapted to shorten a blanking period in the data to accommodate auxiliary data, forming at least one frame; and

   a transmitter communicating with said reformatter and adapted to transmit said at least one frame over the communications link.

Fig. 1

Fig. 2

Fig. 3

Fig. 4

| Front Porch | HSYNC | LineHdr | Audio Data | VSYNC Front Porch |
| Front Porch | HSYNC | LineHdr | Audio Data | VSYNC Front Porch |
| Front Porch | HSYNC | LineHdr | Audio Data | Recommended CTL3 | Modified VSYNC Pulse |
| Front Porch | HSYNC | LineHdr | Audio Data | Modified VSYNC Pulse (Continued) |
| Front Porch | HSYNC | LineHdr | Audio Data | VSYNC Back Porch |
| Front Porch | HSYNC | LineHdr | Audio Data | VSYNC Back Porch |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |

**Fig. 5**

Fig. 6

Fig. 7

Fig. 8

Fig. 9

| Front Porch | HSYNC | Back Porch | VSYNC Front Porch |
|---|---|---|---|
| Front Porch | HSYNC | Back Porch | VSYNC Front Porch |
| Front Porch | HSYNC | Back Porch | Modified VSYNC Pulse |
| Front Porch | HSYNC | LineHdr | Audio Data | Modified VSYNC Pulse (Continued) |
| Front Porch | HSYNC | LineHdr | Audio Data | VSYNC Back Porch |
| Front Porch | HSYNC | LineHdr | Audio Data | VSYNC Back Porch |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |
| Front Porch | HSYNC | LineHdr | Audio Data | Addressable Video |

Fig. 10

| Front Porch | HSYNC | LineHdr | Audio Data | VSYNC Front Porch |
|---|---|---|---|---|
| Front Porch | HSYNC | LineHdr | Audio Data | VSYNC Front Porch |
| Front Porch | HSYNC | LineHdr | Audio Data | VSYNC Porch |
| Front Porch | HSYNC | LineHdr | Back Porch | VSYNC Porch (Continued) |
| Front Porch | HSYNC | | Back Porch | VSYNC Back Porch |
| Front Porch | HSYNC | | Back Porch | VSYNC Back Porch |
| Front Porch | HSYNC | | Back Porch | Addressable Video |
| Front Porch | HSYNC | | Back Porch | Addressable Video |
| Front Porch | HSYNC | | Back Porch | Addressable Video |
| Front Porch | HSYNC | | Back Porch | Addressable Video |
| Front Porch | HSYNC | | Back Porch | Addressable Video |
| Front Porch | HSYNC | | Back Porch | Addressable Video |
| Front Porch | HSYNC | | Back Porch | Addressable Video |
| Front Porch | HSYNC | | Back Porch | Addressable Video |

Fig. 11

| | | | | | | | | | | | |
|---|---|---|---|---|---|---|---|---|---|---|---|
| LineHdr[0] | AudioPixels[7:0] | Preamble0[7:0] | ///// | | | | | | | | Time |
| LineHdr[1] | AudioFormat[7:0] | Preamble2[7:0] | ///// | | | | | | | | |
| LineHdr[2] | AudioWords[7:0] | AudioPixels[7:0] | ///// | | | | | | | | |
| LineHdr[3] | WordLength[7:0] | General[7:0] | ///// | | | | | | | | |
| LineHdr[4] | AudioPixels[7:0] | Remote[7:0] | ///// | ctl3 | ctl2 | ctl1 | ctl0 | vsync | hsync | | |
| LineHdr[5] | AudioRate[7:0] | Preamble1[7:0] | ///// | | | | | | | | |
| LineHdr[6] | Vender[7:0] | CFInfo[7:0] | ///// | | | | | | | | |
| LineHdr[7] | EIACEA861A_Support[7:0] | N_CTS[7:0] | ///// | | | | | | | | |
| LineHdr[8] | N_CTS[23:16] | N_CTS[15:8] | ///// | | | | | | | | |
| LineHdr[9] | N_CTS[39:32] | N_CTS[31:24] | ///// | | | | | | | | |

q23 q22 q21 q20 q19 q18 q17 q16 q15 q14 q13 q12 q11 q10 q9 q8 q7 q6 q5 q4 q3 q2 q1 q0

Channel 2 - red[7:0]    Channel 1 - grn[7:0]    Channel 0 - blu[7:0]

24 Bit Pixel Data

# Fig. 12

Audio Pixels
Total Pixels Equal
$Length(DE_{DVI\ d}) - Length(DE_{DVI-CE})$

Video Pixels

Line Header

Audio Data
(Variable Length)

Video Data

1302 — DVI-CE Link Data | Invalid ⟨⟨⟨⟨⟨⟨⟨⟨⟨⟨⟨⟩⟩ ····· ⟨⟨⟩⟩ ········· ⟨⟨⟩⟩ | Invalid

DVI-CE Tx DE Input (a)

1304 — DVI-1.0 Tx DE Input (b)

1308 — DVI-1.0 Rx DE Output (c)

1310 — DVI-CE Rx DE Output (d)

(a) → [ DVI-CE Tx ] → (b) → [ DVI 1.0 Tx ] → [ DVI 1.0 Rx ] → (c) → [ DVI-CE Rx ] → (d)

1302    1303    1304    1305    1306    1307    1308    1309    1310

# Fig. 13

Fig. 14

PixelClk

OE

TX Data

LineHor[9.0]    Audio Data    P0  P0  P1  P1  P2

This time period is the same duration as the source video horizontal blank

1500    1502

Fig. 15

**Fig. 16**

Fig. 17

Fig. 18

Fig. 19

2002

Collect the line header and the audio data that is to be RS encoded.

LineHdr
| 0 | 1 | 2 | 3 | 4 | 5 | 6 | 7 | 8 | 9 |

Audio Data
| a | b | c | d | e | f | g | h | i |

2003

Split the line header into 5 byte segments. Split the first 20 audio bytes into approximately equal blocks.

2004

Reassemble the line header and audio bytes into two blocks, zero padded to 15 bytes each.

| Zero Padding | 0 | 1 | 2 | 3 | 4 | a | b | c | d | e |

Encode First    Encode Last

| Zero Padding | 5 | 6 | 7 | 8 | 9 | f | g | h | i |

Encode First    Encode Last

2006

Reed-Solomon Encode the two blocks

Interleave First    Interleave Last

| Zero Padding | 0 | 1 | 2 | 3 | 4 | a | b | c | d | e | α | β |

RS Parity Data

Interleave First    Interleave Last

| Zero Padding | 5 | 6 | 7 | 8 | 9 | f | g | h | i | χ | δ |

RS Parity Data

2008

Strip off the zero padding and interleave the two encoded blocks into a single block with maximum length 34 for Transmission

| 0 | 5 | 1 | 6 | 2 | 7 | 3 | 8 | 4 | 9 | a | f | b | g | c | h | d | i | e | χ | α | δ | β |

Transmit First    Transmit Last

Fig. 20

Fig. 21

Fig. 22

**Fig. 23**

2402

Input is two
RS Encoded
blocks up to 17
bytes long

2404

Result of Interleaving
RS blocks into a single
block of up to 34 bytes
for Transmission

**Fig. 24**

Audio Bit 0          Audio Bit 48          Audio Bit 96          Audio Bit 144          Audio Bit 192

Audio Data

| Audio Pixel | Audio Pixel | Audio Pixel | Audio Pixel | Audio Pixel | Audio Pixel | Audio Pixel | Audio Pixel | Audio Pixel | Audio Pixel | Audio Pixel | Audio Pixel |

Line Period          Line Period          Line Period

Transmitted on First Line     Transmitted on Second Line     Transmitted on Third Line

Fig. 25

42

| Audio[0] | 15 | 14 | 13 | 12 | 11 | 10 | 9 | 8 | 7 | 6 | 5 | 4 | 3 | 2 | 1 | 0 | | | | | | | | |
| Audio[1] | 31 | 30 | 29 | 28 | 27 | 26 | 25 | 24 | 23 | 22 | 21 | 20 | 19 | 19 | 17 | 16 | | CTL and SYNC Info | | | | | | |
| Audio[2] | 47 | 46 | 45 | 44 | 43 | 42 | 41 | 40 | 39 | 38 | 37 | 36 | 36 | 34 | 33 | 32 | | | | | | | | |

| q23 | q22 | q21 | q20 | q19 | q18 | q17 | q16 | q15 | q14 | q13 | q12 | q11 | q10 | q9 | q8 | q7 | q8 | q5 | q4 | q3 | q2 | q1 | q0 |

red[7:0]     grn[7:0]     blu[7 0]

16 Bit Audio Pixel Data

24 Bit DVI 1.0 Pixel Data

Time

## Fig. 26

| Audio[0] | 63 | 62 | 61 | 60 | 59 | 58 | 57 | 56 | 55 | 53 | 53 | 52 | 51 | 50 | 49 | 48 |
| Audio[1] | 79 | 78 | 77 | 76 | 75 | 74 | 73 | 72 | 71 | 70 | 69 | 68 | 67 | 66 | 65 | 64 |
| Audio[2] | 95 | 94 | 93 | 92 | 91 | 90 | 89 | 88 | 87 | 86 | 85 | 84 | 83 | 82 | 81 | 80 |
| Audio[3] | 111 | 110 | 109 | 108 | 107 | 106 | 105 | 104 | 103 | 102 | 101 | 100 | 99 | 98 | 97 | 96 |

CTL and SYNC Info

Time

| q23 | q22 | q21 | q20 | q19 | q18 | q17 | q16 | q15 | q14 | q13 | q12 | q11 | q10 | q9 | q8 | q7 | q6 | q5 | q4 | q3 | q2 | q1 | q0 |

red[7:0]  |  grn[7:0]  |  blu[7:0]

16 Bit Audio Pixel Data

24 Bit DVI 1.0 Pixel Data

Fig. 27

Fig. 28

Fig. 29

MSB                                                                    LSB

| Audio[0] | B[15.0] |
| Audio[1] | B[31:16] |
| Audio[2] | C[15:0] |
| Audio[3] | C[31;16] |

CTL and SYNC Info

Time

| q23 | q22 | q21 | q20 | q19 | q18 | q17 | q16 | q15 | q14 | q13 | q12 | q11 | q10 | q9 | q8 | q7 | q6 | q5 | q4 | q3 | q2 | q1 | q0 |

red[7:0]                     grn[7 0]                     blu[7 0]

16 Bit Audio Pixel Data

24 Bit DVI 1.0 Pixel Data

# Fig. 30

Fig. 31

Fig. 32

Fig. 33

**European Patent Office**

## EUROPEAN SEARCH REPORT

Application Number

EP 02 25 0478

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 151 334 A (KIM SUNGJOON ET AL) 21 November 2000 (2000-11-21) | 1-5 | H04N7/52 |
| Y | * abstract * * column 1, line 58 - line 62 * * column 2, line 21 - column 3, line 20 * * column 4, line 15 - line 35 * * column 5, line 28 - line 58 * * column 18, line 59 - column 19, line 33 * | 6-10,20 | |
| A | * figure 17 * | 11-19 | |
| Y | WO 00 14626 A (SILICON IMAGE INC) 16 March 2000 (2000-03-16) | 6-10,20 | |
| A | * abstract * * page 3, line 29 - page 4, line 22 * * page 5, line 21 - line 29 * | 1-5, 11-19 | |
| A | "Silicon Image first to couple digital audio and video on the dvi link" PRESS RELEASES, [Online] 16 January 2001 (2001-01-16), XP002202474 Retrieved from the Internet: <URL:http://www.siimage.com/press/press_print/p_01_16_01.asp> [retrieved on 2002-06-18] * the whole document * | 1-20 | **TECHNICAL FIELDS SEARCHED (Int.Cl.7)** H04N |
| A | FIBUSH D K: "INTEGRATING DIGITAL AUDIO INTO THE SERIAL DIGITAL VIDEO SIGNAL" SMPTE JOURNAL, SMPTE INC. SCARSDALE, N.Y, US, vol. 103, no. 9, 1 September 1994 (1994-09-01), pages 574-579, XP000445483 ISSN: 0036-1682 * the whole document * | 1-20 | |

-/--

The present search report has been drawn up for all claims

| Place of search | Date of completion of the search | Examiner |
|---|---|---|
| THE HAGUE | 20 June 2002 | Fantini, F |

EPO FORM 1503 03.82 (P04C01)

**European Patent Office**

**EUROPEAN SEARCH REPORT**

Application Number

EP 02 25 0478

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | REYNOLDS K Y ET AL: "MULTIPLEXING AND DEMULTIPLEXING DIGITAL AUDIO AND VIDEO IN TODAY'S DIGITAL ENVIRONMENT" SMPTE JOURNAL, SMPTE INC. SCARSDALE, N.Y, US, vol. 102, no. 10, 1 October 1993 (1993-10-01), pages 905-909, XP000409174 ISSN: 0036-1682 * the whole document * | 1-20 | |
| A | "DIGITAL VISUAL INTERFACE DVI" PAPER DIGITAL DISPLAY WORKING GROUP, XX, XX, 2 April 1999 (1999-04-02), pages 1-76, XP002948299 | | |

TECHNICAL FIELDS SEARCHED (Int.Cl.7)

The present search report has been drawn up for all claims

| Place of search | Date of completion of the search | Examiner |
|---|---|---|
| THE HAGUE | 20 June 2002 | Fantini, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 02 25 0478

This annex lists the patent family members relating to the patent documents cited in the above-mentioned European search report.
The members are as contained in the European Patent Office EDP file on
The European Patent Office is in no way liable for these particulars which are merely given for the purpose of information.

20-06-2002

| Patent document cited in search report | | | Publication date | Patent family member(s) | | Publication date |
|---|---|---|---|---|---|---|
| US 6151334 | A | | 21-11-2000 | US | 5835498 A | 10-11-1998 |
| | | | | US | 5999571 A | 07-12-1999 |
| | | | | US | 5905769 A | 18-05-1999 |
| | | | | AU | 3493697 A | 07-01-1998 |
| | | | | CA | 2257997 A1 | 18-12-1997 |
| | | | | EP | 0978049 A1 | 09-02-2000 |
| | | | | JP | 11514815 T | 14-12-1999 |
| | | | | WO | 9748056 A1 | 18-12-1997 |
| | | | | AU | 7202496 A | 28-04-1997 |
| | | | | CA | 2233906 A1 | 10-04-1997 |
| | | | | DE | 69619560 D1 | 04-04-2002 |
| | | | | EP | 0883950 A2 | 16-12-1998 |
| | | | | JP | 3204672 B2 | 04-09-2001 |
| | | | | JP | 11500887 T | 19-01-1999 |
| | | | | WO | 9713347 A2 | 10-04-1997 |
| | | | | US | 6026124 A | 15-02-2000 |
| | | | | US | 5825824 A | 20-10-1998 |
| | | | | AU | 2823697 A | 26-11-1997 |
| | | | | CA | 2251372 A1 | 13-11-1997 |
| | | | | EP | 0897625 A1 | 24-02-1999 |
| | | | | JP | 3112688 B2 | 27-11-2000 |
| | | | | JP | 11511926 T | 12-10-1999 |
| | | | | WO | 9742731 A1 | 13-11-1997 |
| | | | | AU | 7203796 A | 28-04-1997 |
| | | | | CA | 2233709 A1 | 10-04-1997 |
| | | | | EP | 0853852 A1 | 22-07-1998 |
| | | | | JP | 11506289 T | 02-06-1999 |
| | | | | WO | 9713348 A2 | 10-04-1997 |
| | | | | US | 5974464 A | 26-10-1999 |
| WO 0014626 | A | | 16-03-2000 | AU | 6034099 A | 27-03-2000 |
| | | | | WO | 0014626 A1 | 16-03-2000 |

EPO FORM P0459

For more details about this annex : see Official Journal of the European Patent Office, No. 12/82